# EUROPEAN PATENT APPLICATION

(11) **EP 3 038 179 A1**
(43) Date of publication of application: **29.06.2016**
(21) Application number: 15193049.2
(22) Date of filing: 04.11.2015
(51) Int. Cl.: H01L 51/52, H01L 27/32

(54) **ORGANIC LIGHT EMITTING DISPLAY DEVICE AND METHOD OF MANUFACTURING THE SAME**

(30) Priority: 22.12.2014 KR 20140185664
(71) Applicant: Samsung Display Co., Ltd., Gyeonggi-do 17113 (KR)
(72) Inventor: PARK, Sang-Ho, Gyeonggi-Do (KR); PARK, Joung-Keun, Chungcheongnam-do (KR); RYU, Byung-Tae, Seoul (KR); YOO, Hee-Jun, Gyeonggi-do (KR); LEE, Ja-Eun, Suwon-si (KR)
(74) Representative: Taor, Simon Edward William

(57) **Abstract**

An organic light emitting display device includes a substrate including a light-emitting region and a transparent region; a first transistor disposed in the light-emitting region, a second transistor disposed in the light-emitting region and disposed adjacent to the first transistor; a capacitor disposed in the light-emitting region, and disposed adjacent to the first transistor, and including a first capacitor electrode and a second capacitor electrode overlapping with the first capacitor electrode; and a pixel defining layer disposed on the first transistor, the second transistor and the capacitor, and including a first opening disposed in the light-emitting region and a second opening disposed in the transparent region, and including an opaque material.

## Description

Exemplary embodiments relate to an organic light emitting display device and a method of manufacturing the organic light emitting display device. More particularly, exemplary embodiments relate to an organic light emitting display device capable of increasing visibility and a method of manufacturing the organic light emitting display device.

A flat panel display (FPD) device is widely used as a display device in various electronic devices because the flat panel display device is lightweight and thin compared to the traditional cathode-ray tube (CRT) display device. Typical examples of a flat panel display device include a liquid crystal display (LCD) device and an organic light emitting diode (OLED) display device. Compared to the LCD, the OLED has many advantages such as a higher luminance and a wider viewing angle. The OLED display device can be thinner than the traditional LCD device because the OLED display device may not use a backlight. In the OLED display device, electrons and holes are injected into an organic thin layer through a cathode and an anode, and then recombined in the organic thin layer to generate excitons. In this manner, a light of a certain wavelength can be emitted.

Recently, a transparent organic light emitting display device has been developed. The transparent organic light emitting display device may include a transparent region and an opaque region. In the transparent organic light emitting display device, an image of an object in front of or behind a transparent region of the organic light emitting display device may be recognized through the transparent region when the organic light emitting display device is in an ON state. In an OFF state of the organic light emitting display device, an image may be still be displayed in a pixel region of the organic light emitting display device.

In the conventional transparent organic light emitting display device, since transistors and capacitors are positioned in an opaque region, light due to reflection by metal wirings may be incident to the opaque region. Therefore, blurring of images may occur.

The above information disclosed in this Background section is only for enhancement of understanding of the background of the inventive concept, and, therefore, it may contain information that does not form the prior art that is already known in this country to a person of ordinary skill in the art.

Exemplary embodiments provide an organic light emitting display device capable of increasing visibility.

Exemplary embodiments also provide a method of manufacturing the organic light emitting display device.

Additional features of the invention will be set forth in the description which follows, and in part will be apparent from the description, or may be learned by practice of the invention.

An exemplary embodiment discloses an organic light emitting display device including a substrate including a light-emitting region and a transparent region, a first transistor disposed in the light-emitting region, a second transistor disposed in the light-emitting region and disposed adjacent to the first transistor, a capacitor disposed in the light-emitting region, and disposed adjacent to the first transistor, and including a first capacitor electrode and a second capacitor electrode overlapping with the first capacitor electrode and a pixel defining layer disposed on the first transistor, the second transistor and the capacitor, and including a first opening disposed in the light-emitting region and a second opening disposed in the transparent region, and including an opaque material.

An exemplary embodiment also discloses a method of manufacturing an organic light emitting display device including forming a buffer layer on a substrate including a light-emitting region and a transparent region, forming a first transistor, a second transistor and a capacitor on the buffer layer in the light-emitting region and forming a pixel defining layer on the first transistor, the second transistor and the capacitor. The pixel defining layer includes a first opening disposed in the light-emitting region and a second opening disposed in the transparent region. The pixel defining layer includes an opaque material.

It is to be understood that both the foregoing general description and the following detailed description are exemplary and explanatory and are intended to provide further explanation of the invention as claimed.

The accompanying drawings, which are included to provide a further understanding of the inventive concept, and are incorporated in and constitute a part of this specification, illustrate exemplary embodiments of the inventive concept, and, together with the description, serve to explain principles of the inventive concept.

FIG. 1 is a plan view illustrating an organic light emitting display device according to an exemplary embodiment.

FIG. 2 is a cross-sectional view taken along the line I-I' of FIG. 1.

FIGS. 3, 4, 5, 6, 7, 8, 9, 10, and 11 are cross-sectional views illustrating a method of manufacturing the organic light emitting display device of FIG. 2.

FIG. 12 is a cross-sectional view illustrating an organic light emitting display device according to an exemplary embodiment.

FIGS. 13, 14, and 15 are cross-sectional views illustrating a method of manufacturing the organic light emitting display device of FIG. 12.

FIG. 16 is a cross-sectional view illustrating an organic light emitting display device according to an exemplary embodiment.

FIGS. 17, 18, and 19 are cross-sectional views illustrating a method of manufacturing the organic light emitting display device of FIG. 16.

FIG. 20 is a cross-sectional view illustrating an organic light emitting display device according to an exemplary embodiment.

FIGS. 21, 22, and 23 are cross-sectional views illustrating a method of manufacturing the organic light emitting display device of FIG. 20.

FIG. 24 is a cross-sectional view illustrating an organic light emitting display device according to an exemplary embodiment.

FIGS. 25, 26, and 27 are cross-sectional views illustrating a method of manufacturing the organic light emitting display device of FIG. 24.

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the size and relative sizes of layers and regions may be exaggerated for clarity.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, the present invention will be described in detail with reference to the accompanying drawings.

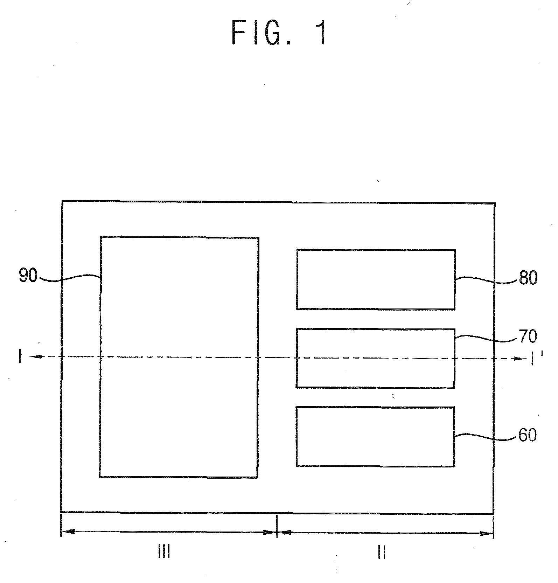

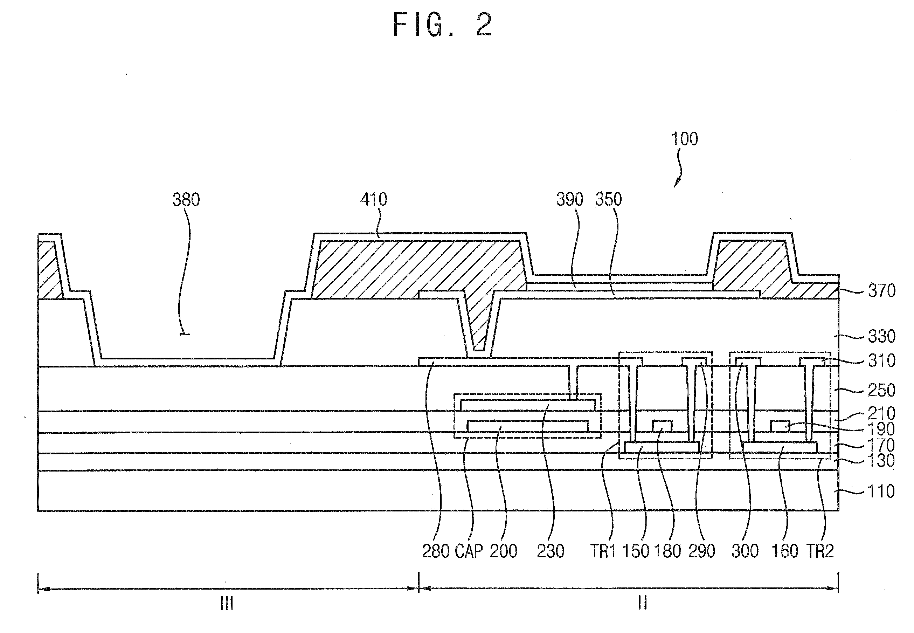

FIG. 1 is a plan view illustrating an organic light emitting display device according to an exemplary embodiment. FIG. 2 is a cross-sectional view taken along the line I-I' of FIG. 1.

Referring to FIGS. 1 and 2, an organic light emitting display device according to an exemplary embodiment may include a light-emitting region II and a transparent region III. Pixels 60, 70, and 80 may be positioned in the light-emitting region II, and a transparent window 90 may be positioned in the transparent region III. For example, the pixel 60 may be a pixel emitting a red color, the pixel 70 may be a pixel emitting a green color, and the pixel 80 may be a pixel emitting a blue color. The transparent window 90 may transmit an external light. Here, wires or lines (e.g., data lines, scan lines, power supply electrodes, etc.) and insulating layers (e.g., a pixel defining layer, VIA layer, etc.) may be disposed in an area (e.g., a dead space) surrounding the pixels 60, 70, and 80 and the transparent window 90. In some embodiments, the organic light emitting display device comprises a plurality of pixels, with each pixel comprising sub-pixels 60, 70, and 80 and a transparent window 90.

The organic light emitting display device 100 may include a substrate 110, a driving transistor TR1, a switching transistor TR2, a storage capacitor CAP, a power supply electrode 280, a buffer layer 130, an insulating interlayer 170, a gate insulating layer 210, a first insulating layer 250, a second insulating layer 330, a first electrode 350, a pixel defining layer 370, a transparent window 380, an emission layer 390, a second electrode 410, etc. In exemplary embodiments, the organic light emitting display device 100 may include a light-emitting region II and a transparent region III. The driving transistor TR1, the switching transistor TR2, the storage capacitor CAP, the power supply electrode 280, the second insulating layer 330, the first electrode 350, the emission layer 390 may be positioned in the light-emitting region II. The transparent window 380 may be positioned in the transparent region III. In exemplary embodiments, an image may be displayed in the light-emitting region II, and objects or images located opposite to the organic light emitting display device 100 may be transmitted in the transparent region III.

In some embodiments, each of the pixels 60, 70, and 80 (which could be sub-pixels of a pixel) comprise a transistor TR1, a switching transistor TR2, and a storage capacitor CAP. For each pixel, the pixel defining layer 370 defines emission regions and the transparent window 380.

The substrate 110 may include a transparent inorganic material or flexible plastic. For example, the substrate 110 may include a glass substrate, a quartz substrate, etc. Alternatively, the substrate 110 may include a flexible transparent resin substrate. Here, the flexible transparent resin substrate for the substrate 110 may include a polyimide substrate. For example, the polyimide substrate may include a first polyimide layer, a barrier film layer, a second polyimide layer, etc.

In some exemplary embodiments, the substrate 110 may have a structure in which the first polyimide layer, the barrier film layer and the second polyimide layer are stacked on a glass substrate. Here, after an insulation layer is provided on the second polyimide layer, upper structures including a light emitting structure (e.g., the driving transistor TR1, the switching transistor TR2, the storage capacitor CAP, the power supply electrode 280, the first electrode 350, the emission layer 390, the second electrode 410, etc.) may be disposed on the insulation layer. After the upper structures are formed on the insulation layer, the glass substrate may be removed. It may be difficult to directly form the upper structures on the polyimide substrate because the polyimide substrate is thin and flexible. Accordingly, the upper structures are formed on a rigid glass substrate, and then the polyimide substrate may replace the rigid glass substrate 110 after the glass substrate is removed. As the organic light emitting display device 100 may include the light-emitting region II and the transparent region III, the substrate 110 may also include the light-emitting region II and the transparent region III.

The buffer layer 130 may be disposed on the substrate 110. As illustrated in FIG. 2, the buffer layer 130 may extend from the light-emitting region II into the transparent region III. The buffer layer 130 may prevent the diffusion (e.g., an out gassing) of metal atoms and/or impurities from the substrate 110. The buffer layer 130 may also control a rate of a heat transfer in a crystallization process for forming a first active pattern 150 and a second active pattern 160, thereby obtaining substantially uniform first and second active patterns 150 and 160.

Furthermore, the buffer layer 130 may improve surface flatness of the substrate 110 when a surface of the substrate 110 is relatively irregular. For example, the buffer layer 130 may include silicon nitride, silicon oxide, etc. In some exemplary embodiments, only one buffer layer or no buffer layer may be provided on the substrate 105 in accordance with the type of the substrate 105. When the buffer layer 130 includes silicon oxide, an external light penetrating the transparent region III of the organic light emitting display device 100 may transmit through the buffer layer 130.

In some exemplary embodiments, according to a type of the substrate 110, two or more buffer layers may be provided on the substrate 110, or the buffer layer may not be included at all.

The driving transistor TR1 may be disposed on the buffer layer 130. In exemplary embodiments, the driving transistor TR1 may include a first active pattern 150, the insulating interlayer 170, a first gate electrode 180, the gate insulating layer 210, the first insulating layer 250, a first source electrode (part of power supply electrode 280), a first drain electrode 290, etc. Here, the first source electrode may be connected to the power supply electrode 280, and a high power supply voltage ELVDD may be applied to the first source electrode. For example, the organic light emitting display device 100 may include the power supply electrode 280 (e.g., a high power supply electrode) and a low power supply electrode (not shown). The high power supply voltage ELVDD may be provided to the power supply electrode 280, and the low power supply voltage ELVSS may be provided to the low power supply electrode.

The switching transistor TR2 may be disposed on the buffer layer 130. In exemplary embodiments, the switching transistor TR2 may include a second active pattern 160, the insulating interlayer 170, a second gate electrode 190, the gate insulating layer 210, the first insulating layer 250, a second source electrode 300, a second drain electrode 310, etc.

The storage capacitor CAP may be disposed on the insulating interlayer 170. In exemplary embodiments, the storage capacitor CAP may include a first capacitor electrode 200, the gate insulating layer 210, a second capacitor electrode 230, etc. Here, the second capacitor electrode 230 may be connected to the power supply electrode 280, and the high power supply voltage ELVDD may be applied to the second capacitor electrode 230.

In exemplary embodiments, the driving transistor TR1 and the switching transistor TR2 may be positioned in the light-emitting region II. In the driving transistor TR1 and the switching transistor TR2, the first and second active patterns 150 and 160 may be disposed spacing apart from each other by a predetermined distance in the light-emitting region II on the buffer layer 130. Each of the first and second active patterns 150 and 160 may be a semiconductor device which may include an active layer containing an oxide semiconductor, an inorganic semiconductor (including amorphous silicon, polysilicon, etc.), an organic semiconductor, etc. The insulating interlayer 170 may be disposed on the buffer layer 130. The insulating interlayer 170 may cover the first and second active patterns 150 and 160, and may extend into the transparent region III. The insulating interlayer 170 may include a silicon compound, a metal oxide, etc. In exemplary embodiments, the insulating interlayer 170 may include a silicon oxide. In some exemplary embodiments, the insulating interlayer 170 may include a material substantially the same as that of the buffer layer 130. In this case, as the insulating interlayer 170 and the buffer layer 130 may be formed as the same material in the transparent region III, the insulating interlayer 170 and the buffer layer 130 may have the same refractive index. Thus, a light transmittivity may be improved in the transparent region III.

The first gate electrode 180 may be disposed on the insulating interlayer 170 under which the first active pattern 150 is positioned. The second gate electrode 190 may be disposed on the insulating interlayer 170 under which the second active pattern 160 is positioned. Each of the first gate electrode 180 and the second gate electrode 190 may include, for example, metal, alloy, metal nitride, conductive metal oxide, a transparent conductive material, etc.

The first capacitor electrode 200 may be disposed on the insulating interlayer 170. The first capacitor electrode 200 may be spaced apart from the first gate electrode 180 by a predetermined distance. The first capacitor electrode 200, the first gate electrode 180, and the second gate electrode 190 may include substantially the same material. However, in some exemplary embodiments, each of the first capacitor electrode 200, the first gate electrode 180, and the second gate electrode 190 may include different materials.

The gate insulating layer 210 may be disposed on the insulating interlayer 170, the first capacitor electrode 200, the first gate electrode 180, and the second gate electrode 190. The gate insulating layer 210 may cover the first capacitor electrode 200, the first gate electrode 180, and the second gate electrode 190, and may extend into the transparent region III. The gate insulating layer 210 may include a silicon compound, a metal oxide, etc. In some exemplary embodiments, the gate insulating layer 210 may include a silicon oxide. In some exemplary embodiments, the gate insulating layer 210 may include a material substantially the same as that of the buffer layer 130 and the insulating interlayer 170. In this case, as the gate insulating layer 210, the insulating interlayer 170 and the buffer layer 130 may be formed as the same material in the transparent region III, the gate insulating layer 210, the insulating interlayer 170 and the buffer layer 130 may have the same refractive index. Thus, a light transmittivity may be improved in the transparent region III.

The second capacitor electrode 230 may be disposed on the gate insulating layer 210 under which the first capacitor electrode 200 is positioned. The second capacitor electrode 230 may include a material substantially the same that of the first gate electrode 180, the second gate electrode 190, and the first capacitor electrode 200. However, in some exemplary embodiments, each of the second capacitor electrode 230, the first gate electrode 180, the second gate electrode 190, and the first capacitor electrode 200 may include different materials.

The first insulating layer 250 may be disposed on the gate insulating layer 210 and the second capacitor electrode 230. The first insulating layer 250 may cover the second capacitor electrode 230, and may extend into the transparent region III. For example, the first insulating layer 250 may include a silicon compound, a metal oxide, etc. In exemplary embodiments, the first insulating layer 250 may include a silicon oxide. In some exemplary embodiments, the first insulating layer 250 may include materials substantially the same as that of the gate insulating layer 210, the buffer layer 130 and the insulating interlayer 170. In this case, as the first insulating layer 250, the gate insulating layer 210, the insulating interlayer 170 and the buffer layer 130 may be formed as the same material in the transparent region III, the first insulating layer 250, the gate insulating layer 210, the insulating interlayer 170 and the buffer layer 130 may have the same refractive index. Thus, a light transmittivity may be improved in the transparent region III. Accordingly, a definition of objects or images located opposite to the organic light emitting display device 100 may be increased. A thickness of the first insulating layer 250 may be substantially greater than that of the gate insulating layer 210. In exemplary embodiments, as a thickness the first insulating layer 250 is relatively increased, a coupling phenomenon that is generated between the power supply electrode 280 and the second capacitor electrode 230 may be reduced.

The power supply electrode 280, the first source electrode of the driving transistor TR1, the first drain electrode 290 of the driving transistor TR1, the second source electrode 300 of the switching transistor TR2, the second drain electrode 310 of the switching transistor TR2, a portion of the second insulating layer 330, and a portion of the first electrode 350 may be disposed in the light-emitting region II of the first insulating layer 250. A portion of the pixel defining layer 370 and a portion of the second electrode 410 may be disposed on the transparent region III of the first insulating layer 250.

The first source electrode and the first drain electrode 290 may be contacted to the first active pattern 150 by removing portions of the first insulating layer 250, the gate insulating layer 210, and the insulating interlayer 170. Each of the first source electrode and the first drain electrode 290 may include at least one of metal, alloy, metal nitride, conductive metal oxide, a transparent conductive material, etc.

The second source electrode 300 and the second drain electrode 310 may be contacted to the second active pattern 160 by removing portions of the first insulating layer 250, the gate insulating layer 210, and the insulating interlayer 170. Each of the second source electrode 300 and the second drain electrode 310 may include materials substantially the same as that of the first source electrode and the first drain electrode 290.

The power supply electrode 280 may be electrically contacted to the second capacitor electrode 230 by removing a portion of the first insulating layer 250, and may be electrically contacted to the first active pattern 150 by removing a portion of the first insulating layer 250, the gate insulating layer 210, and the insulating interlayer 170. The high power supply voltage ELVDD applied to the power supply electrode 280 may be provided to the second capacitor electrode 230 and the first active pattern 150. The power supply electrode 280 may include materials substantially the same as that of the first drain electrode 290, the second source electrode 300, and the second drain electrode 310.

The second insulating layer 330 may cover the first source electrode, the first drain electrode 290, the second source electrode 300, and the second drain electrode 310. The second insulating layer 330 may be disposed such that the second insulating layer 330 is overlapped with a portion of the power supply electrode 280. That is, at least a portion of the power supply electrode 280 may be exposed by the second insulating layer 330. The second insulating layer 330 may include an inorganic material. For example, the second insulating layer 330 may include at least one of a silicon compound such as silicon oxide (SiOx), silicon nitride (SiNx), silicon oxynitride (SiOxNy), silicon oxycarbide (SiOxCy), silicon carbonitride (SiCxNy), etc. In some exemplary embodiments, the second insulating layer 330 may include an organic material. For example, the second insulating layer 330 may include at least one of polyimide-based resin, photoresist, acrylic-based resin, polyamide-based resin, siloxane-based resin, etc.

The first electrode 350 may be disposed on a portion of the first insulating layer 250, a portion of the power supply electrode 280, and a portion of the second insulating layer 330 in the light-emitting region II. In exemplary embodiments, the first electrode 350 may be disposed so as to have a substantially uniform thickness along a profile of the power supply electrode 280 and the second insulating layer 330.

The first electrode 350 may include metal, alloy, metal nitride, conductive metal oxide, a transparent conductive material, etc. For example, the first electrode 350 may include at least one of aluminum (Al), aluminum alloy, aluminum nitride (AlNx), silver (Ag), silver alloy, tungsten (W), tungsten nitride (WNx), copper (Cu), copper alloy, nickel (Ni), chromium (Cr), chromium nitride (CrNx), molybdenum (Mo), molybdenum alloy, titanium (Ti), titanium nitride (TiNx), platinum (Pt), tantalum (Ta), tantalum nitride (TaNx), neodymium (Nd), scandium (Sc), strontium ruthenium oxide (SRO), zinc oxide (ZnOx), indium tin oxide (ITO), tin oxide (SnOx), indium oxide (InOx), gallium oxide (GaOx), indium zinc oxide (IZO), etc.

The pixel defining layer 370 may be disposed on the first electrode 350, a portion of the second insulating layer 330, and a portion of the first insulating layer 250. The pixel defining layer 370 may include a first opening and a second opening. In the light-emitting region II, the first opening of the pixel defining layer 370 may be positioned in a portion of the first electrode 350 disposed on the second insulating layer 330. The emission layer 390 may be disposed in the first opening. The second opening of the pixel defining layer 370 may be positioned in the transparent region III. The second opening may be defined as the transparent window 380. The pixel defining layer 370 may include organic materials or inorganic materials used alone or in a combination thereof. In some exemplary embodiments, the pixel defining layer 370 may include materials substantially the same as that of the second insulating layer 330.

In exemplary embodiments, the pixel defining layer 370 may include an opaque material. For example, the pixel defining layer 370 may include a white organic material such as include zirconium oxide (ZrOx) and/or titanium oxide (TiOx). Therefore, the pixel defining layer 370 may block light due to reflection by metal wirings. That is, the pixel defining layer 370 may block light incident to the light-emitting region II, and thus blurring of images may be prevented or reduced.

However, exemplary embodiments are not limited thereto. The pixel defining layer 370 may include organic materials of various colors. For example, the pixel defining layer 370 may include an opaque organic material having a red color, a green color, or a blue color.

The emission layer 390 may be disposed on the first electrode 350 which is exposed via the first opening of the pixel defining layer 370. The emission layer 390 may be formed using light emitting materials capable of generating different colors of light (e.g., a red color of light, a blue color of light, and a green color of light). In some exemplary embodiments, the emission layer 390 may generally generate a white color of light by stacking a plurality of light emitting materials capable of generating different colors of light such as a red color of light, a green color of light, a blue color of light, etc.

The second electrode 410 may be disposed on the pixel defining layer 370, the emission layer 390, and the first insulating layer 250. The second electrode 410 may be disposed as a substantially uniform thickness along a profile of the pixel defining layer 370, the emission layer 390, and the first insulating layer 250. The second electrode 410 may contact a portion of the first insulating layer 250 via the second opening of the pixel defining layer 370, and may extend into the transparent region III. That is, the second electrode 410 may extend into the second opening. In exemplary embodiments, the second electrode 410 may include a transparent conductive material. For example, the second electrode 410 may include ITO, SnOx, InOx, GaOx, IZO, etc. Thus, the second electrode 410 positioned in the transparent region III may not substantially reduce transmittivity of the transparent region III. In some exemplary embodiments, the second electrode 410 may include materials substantially the same as that of the first electrode 350.

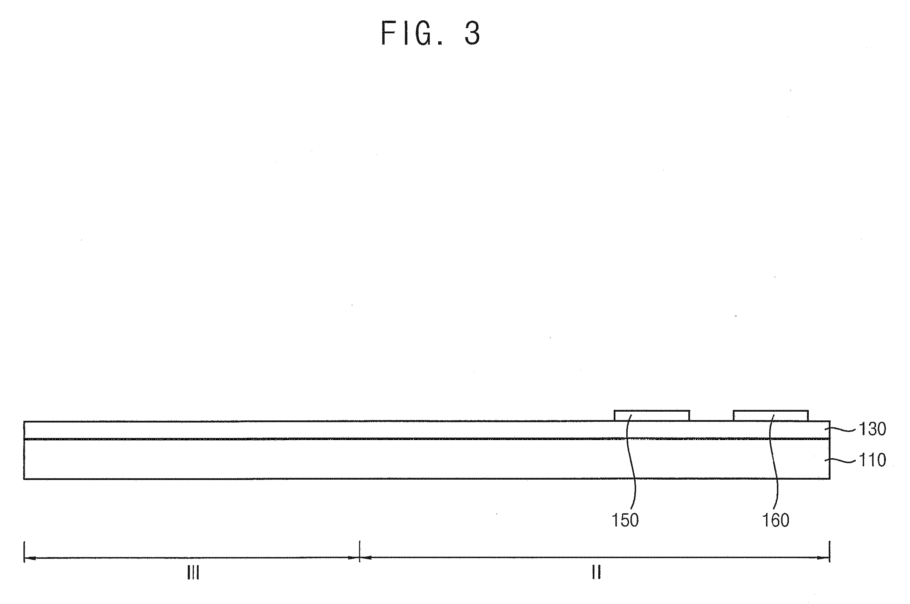

FIGS. 3 to 11 are cross-sectional views illustrating a method of manufacturing the organic light emitting display device of FIG. 2.

Referring to FIG. 3, a buffer layer 130 is formed on a substrate 110. Thereafter, a first active pattern 150 and a second active pattern 160 are formed on the buffer layer 130.

The buffer layer 130 may extend from the light-emitting region II into the transparent region III. The buffer layer 130 may prevent the diffusion (e.g., an out gassing) of metal atoms and/or impurities from the substrate 110. In some exemplary embodiments, the buffer layer 130 may control a rate of a heat transfer in a crystallization process for forming a first active pattern 150 and a second active pattern 160, thereby obtaining substantially uniform first and second active patterns 150 and 160.

The buffer layer 130 may improve a surface flatness of the substrate 110 when a surface of the substrate 110 is relatively irregular. For example, the buffer layer 130 may include silicon nitride, silicon oxide, etc. In some exemplary embodiments, only one buffer layer or no buffer layer may be provided on the substrate 105 in accordance with the type of material used for the substrate 105. When the buffer layer 130 includes the silicon oxide, an external light penetrated to the transparent region III of the organic light emitting display device 100 may be transmitted through the buffer layer 130.

In some exemplary embodiments, according to a type of material used for the substrate 110, at least two buffer layers may be provided on the substrate 110, or the buffer layer may not be included.

The first and the second active patterns 150 and 160 may be positioned on the buffer layer 130 in the light-emitting region II. The second active pattern 160 may be spaced apart from the first active pattern 150 along the first direction. Each of the first and the second active patterns 150 and 160 may include a material containing a silicon or an oxide semiconductor.

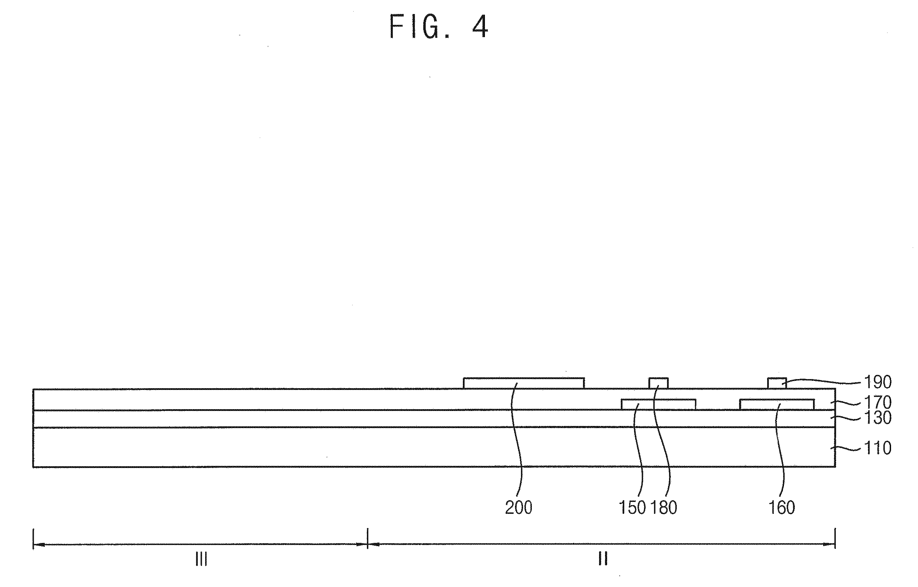

Referring to FIG. 4, a insulating interlayer 170 is formed on the substrate 110 on which the buffer layer 130 is formed. Thereafter, a first gate electrode 180, a second gate electrode 190 and a first capacitor electrode 200 are formed on the insulating interlayer 170.

The insulating interlayer 170 may be disposed on the buffer layer 130. The insulating interlayer 170 may cover the first and second active patterns 150 and 160, and may extend into the transparent region III. In some exemplary embodiments, the insulating interlayer 170 may include a silicon compound, a metal oxide, etc. In exemplary embodiments, the insulating interlayer 170 may include a silicon oxide. In some exemplary embodiments, the insulating interlayer 170 may include a material substantially the same as that of the buffer layer 130. In this case, as the insulating interlayer 170 and the buffer layer 130 may be formed as the same material in the transparent region III, the insulating interlayer 170 and the buffer layer 130 may have the same refractive index. Thus, a light transmittivity may be improved in the transparent region III.

The first gate electrode 180 may be disposed on the insulating interlayer 170 under which the first active pattern 150 is positioned. The second gate electrode 190 may be disposed on the insulating interlayer 170 under which the second active pattern 160 is positioned. Each of the first gate electrode 180 and the second gate electrode 190 may include at least one of metal, alloy, metal nitride, conductive metal oxide, a transparent conductive material, etc.

The first capacitor electrode 200 may be disposed on the insulating interlayer 170. The first capacitor electrode 200 may be spaced apart from the first gate electrode 180 by a predetermined distance. The first capacitor electrode 200, the first gate electrode 180, and the second gate electrode 190 may include substantially the same material. However, in some exemplary embodiments, each of the first capacitor electrode 200, the first gate electrode 180, and the second gate electrode 190 may include different materials.

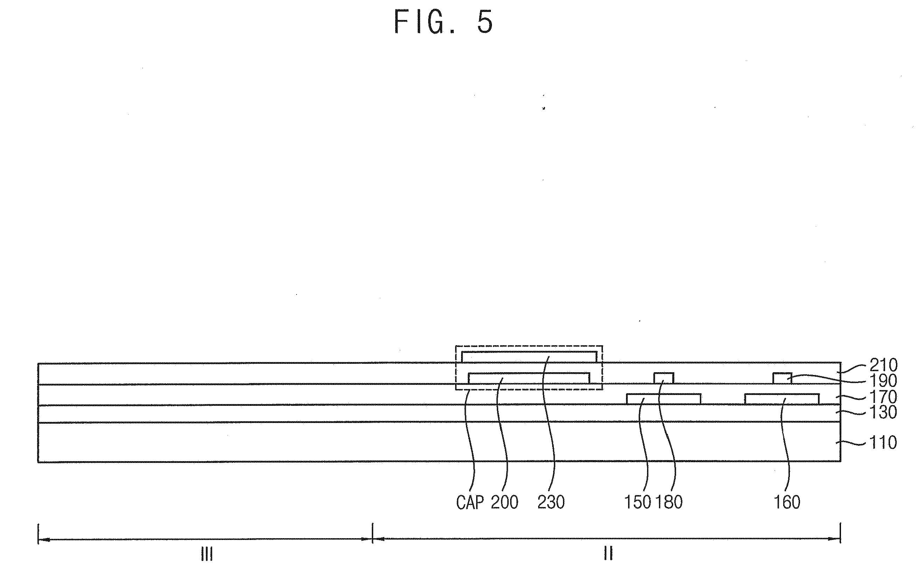

Referring to FIG. 5, a gate insulating layer 210 is formed on the substrate 110 on which the first gate electrode 180, the second gate electrode 190 and the first capacitor electrode 200 are formed. Thereafter, a second capacitor electrode 230 is formed on the gate insulating layer 210.

The gate insulating layer 210 may be disposed on the insulating interlayer 170, the first capacitor electrode 200, the first gate electrode 180, and the second gate electrode 190. The gate insulating layer 210 may cover the first capacitor electrode 200, the first gate electrode 180, and the second gate electrode 190, and may extend into the transparent region III. In exemplary embodiments, the gate insulating layer 210 may include a silicon compound, a metal oxide, etc. In exemplary embodiments, the gate insulating layer 210 may include a silicon oxide. In some exemplary embodiments, the gate insulating layer 210 may include a material substantially the same as that of the buffer layer 130 and the insulating interlayer 170. In this case, as the gate insulating layer 210, the insulating interlayer 170 and the buffer layer 130 may be formed as the same material in the transparent region III, the gate insulating layer 210, the insulating interlayer 170 and the buffer layer 130 may have the same refractive index. Thus, a light transmittivity may be improved in the transparent region III.

The second capacitor electrode 230 may be disposed on the gate insulating layer 210 under which the first capacitor electrode 200 is positioned. The second capacitor electrode 230 may include a material substantially the same that of the first gate electrode 180, the second gate electrode 190, and the first capacitor electrode 200. However, in some exemplary embodiments, each of the second capacitor electrode 230, the first gate electrode 180, the second gate electrode 190, and the first capacitor electrode 200 may include different materials.

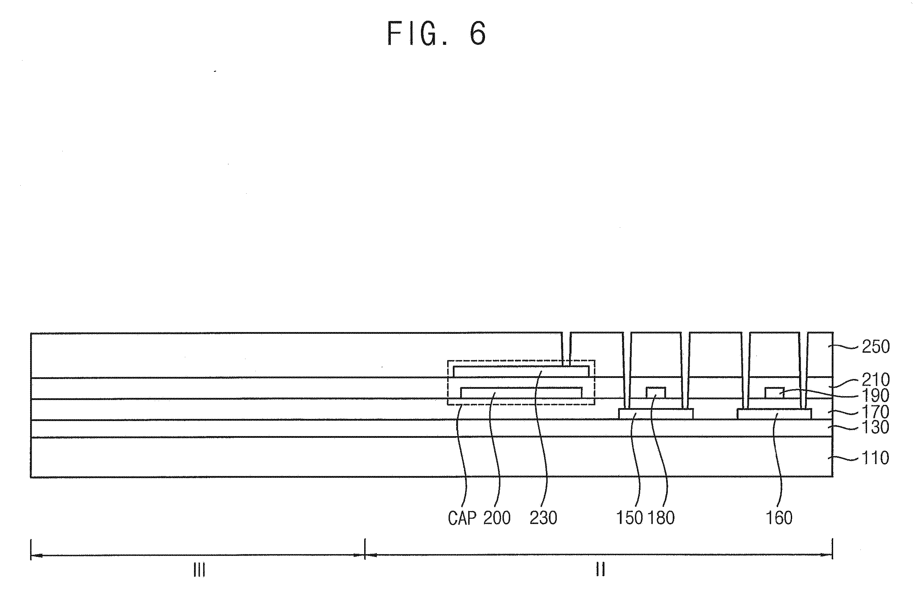

Referring to FIG. 6, a first insulating layer 250 is formed on the substrate 110 on which the second capacitor electrode 230 is formed. Thereafter, a contact hole penetrating the first insulating layer 250 and contact holes penetrating the first insulating layer 250, the gate insulating layer 210 and the insulating interlayer 170 are formed.

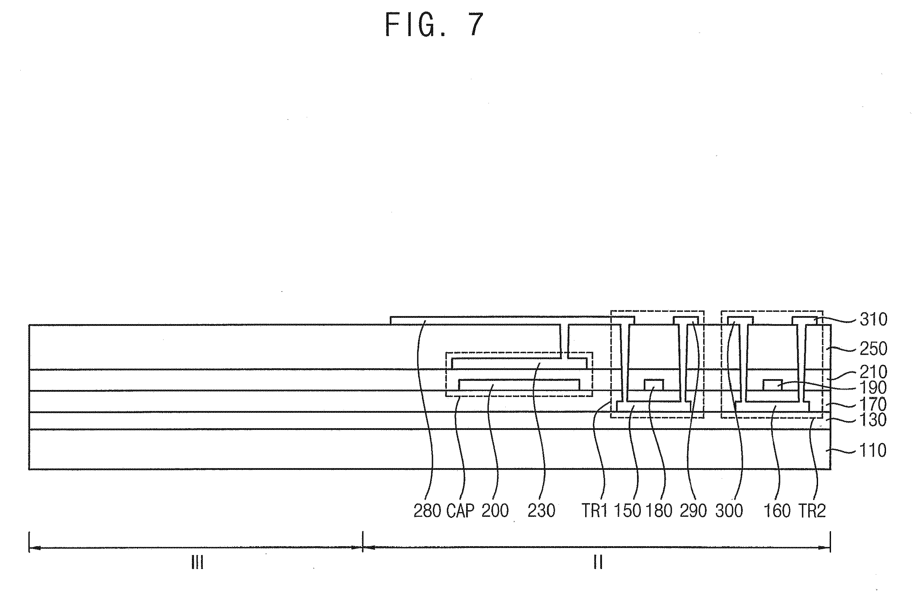

Referring to FIG. 7, a first source electrode (connected to power supply electrode 280), a first drain electrode 290, a second source electrode 300, a second drain electrode 310 and a power supply electrode 280 are formed.

The first source electrode and the first drain electrode 290 may be contacted to the first active pattern 150 by removing portions of the first insulating layer 250, the gate insulating layer 210, and the insulating interlayer 170. Each of the first source electrode and the first drain electrode 290 may include at least one of metal, alloy, metal nitride, conductive metal oxide, a transparent conductive material, etc.

The second source electrode 300 and the second drain electrode 310 may be contacted to the second active pattern 160 by removing portions of the first insulating layer 250, the gate insulating layer 210, and the insulating interlayer 170. Each of the second source electrode 300 and the second drain electrode 310 may include materials substantially the same as that of the first source electrode and the first drain electrode 290.

The power supply electrode 280 may be electrically contacted to the second capacitor electrode 230 by removing a portion of the first insulating layer 250, and may be electrically contacted to the first active pattern 150 by removing a portion of the first insulating layer 250, the gate insulating layer 210, and the insulating interlayer 170. The high power supply voltage ELVDD applied to the power supply electrode 280 may be provide to the second capacitor electrode 230 and the first active pattern 150. The power supply electrode 280 may include materials substantially the same as that of the first drain electrode 290, the second source electrode 300, and the second drain electrode 310.

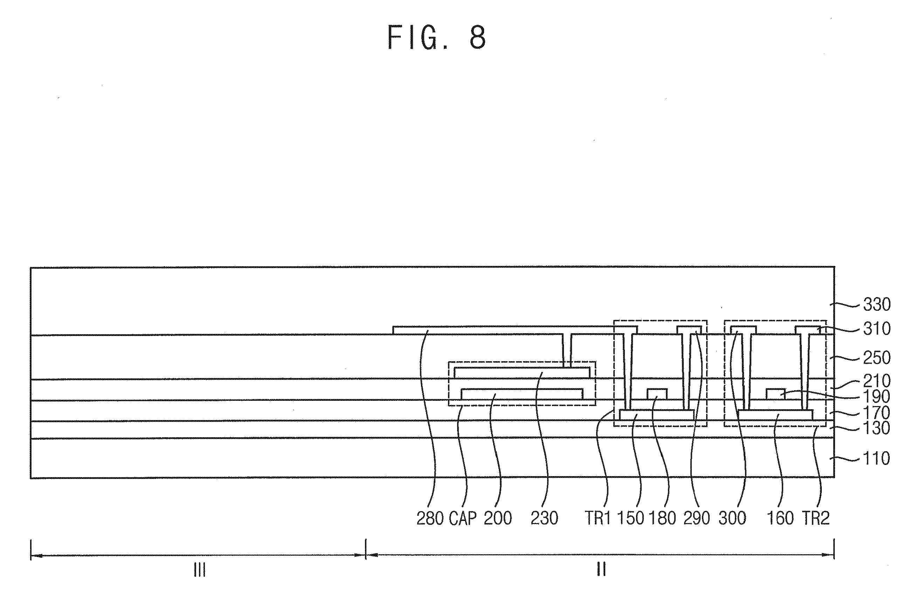

Referring to FIG. 8, a second insulating layer 330 is formed on the substrate 110 on which the first source electrode, the first drain electrode 290, the second source electrode 300, the second drain electrode 310 and the power supply electrode 280 are formed.

The second insulating layer 330 may include an inorganic material. For example, the second insulating layer 330 may include at least one silicon compound such as silicon oxide (SiOx), silicon nitride (SiNx), silicon oxynitride (SiOxNy), silicon oxycarbide (SiOxCy), silicon carbonitride (SiCxNy), etc. In some exemplary embodiments, the second insulating layer 330 may include an organic material. For example, the second insulating layer 330 may include at least one of polyimide-based resin, photoresist, acrylic-based resin, polyamide-based resin, siloxane-based resin, etc.

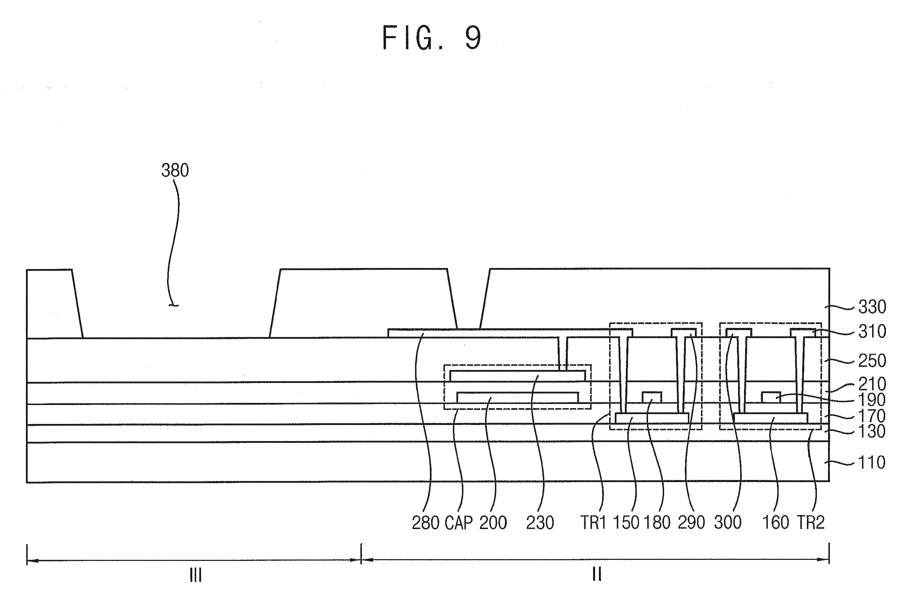

Referring to FIG. 9, the second insulating layer 330 is patterned to form a transparent window 380 and a contact hole.

The second insulating layer 330 may cover the first source electrode, the first drain electrode 290, the second source electrode 300, and the second drain electrode 310. The second insulating layer 330 may be disposed such that the second insulating layer 330 is overlapped with a portion of the power supply electrode 280. That is, at least a portion of the power supply electrode 280 may be exposed by the second insulating layer 330.

The second insulating layer 330 may include an inorganic material. For example, the second insulating layer 330 may include at least one of a silicon compound such as silicon oxide (SiOx), silicon nitride (SiNx), silicon oxynitride (SiOxNy), silicon oxycarbide (SiOxCy), silicon carbonitride (SiCxNy), etc. In some exemplary embodiments, the second insulating layer 330 may include an organic material. For example, the second insulating layer 330 may include at least one of polyimide-based resin, photoresist, acrylic-based resin, polyamide-based resin, siloxane-based resin, etc.

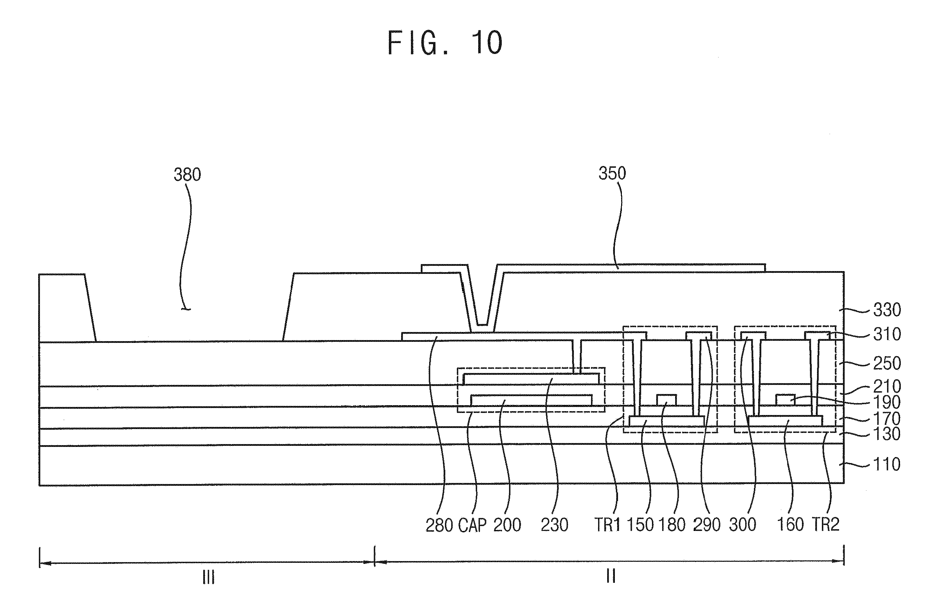

Referring to FIG. 10, a first electrode 350 is formed on the second insulating layer 330.

The first electrode 350 may be disposed on a portion of the first insulating layer 250, a portion of the power supply electrode 280, and a portion of the second insulating layer 330 in the light-emitting region II. In exemplary embodiments, the first electrode 350 may be disposed to have a substantially uniform thickness along a profile of the power supply electrode 280 and the second insulating layer 330.

The first electrode 350 may include at least one of metal, alloy, metal nitride, conductive metal oxide, a transparent conductive material, etc. For example, the first electrode 350 may include at least one of aluminum (Al), aluminum alloy, aluminum nitride (AlNx), silver (Ag), silver alloy, tungsten (W), tungsten nitride (WNx), copper (Cu), copper alloy, nickel (Ni), chromium (Cr), chromium nitride (CrNx), molybdenum (Mo), molybdenum alloy, titanium (Ti), titanium nitride (TiNx), platinum (Pt), tantalum (Ta), tantalum nitride (TaNx), neodymium (Nd), scandium (Sc), strontium ruthenium oxide (SRO), zinc oxide (ZnOx), indium tin oxide (ITO), tin oxide (SnOx), indium oxide (InOx), gallium oxide (GaOx), indium zinc oxide (IZO), etc.

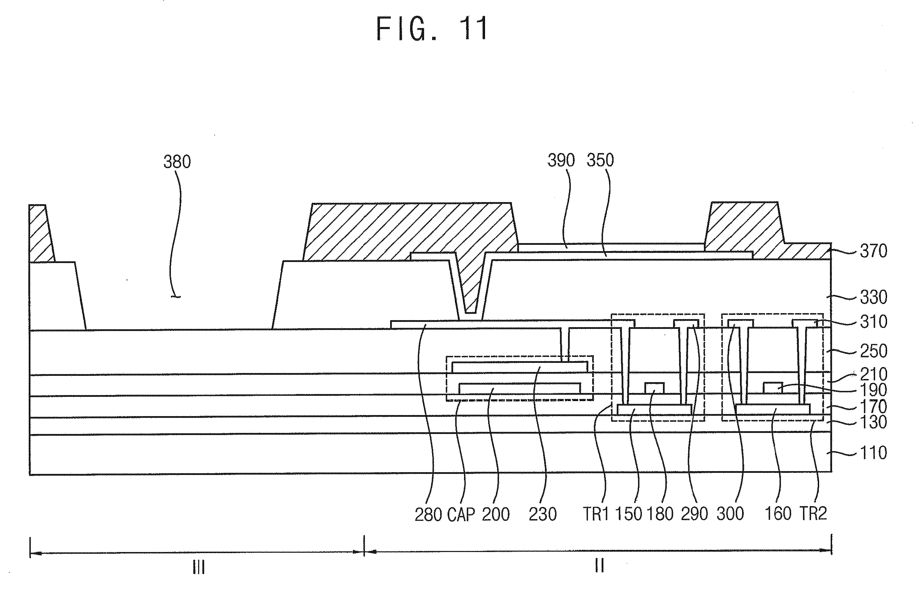

Referring to FIG. 11, a pixel defining layer 370 is formed on the substrate 110 on which the first electrode 350 is formed. Thereafter, an emission layer 390 is formed on the first electrode 350 which is exposed via the first opening of the pixel defining layer 370.

The pixel defining layer 370 may be disposed on the first electrode 350, a portion of the second insulating layer 330, and a portion of the first insulating layer 250. The pixel defining layer 370 may include a first opening and a second opening. In the light-emitting region II, the first opening of the pixel defining layer 370 may be positioned in a portion of the first electrode 350 disposed on the second insulating layer 330. The emission layer 390 may be disposed in the first opening. The second opening of the pixel defining layer 370 may be positioned in the transparent region III. The second opening may be defined as the transparent window 380. The pixel defining layer 370 may include organic materials or inorganic materials. These may be used alone or in a combination thereof. In some exemplary embodiments, the pixel defining layer 370 may include materials substantially the same as that of the second insulating layer 330.

In exemplary embodiments, the pixel defining layer 370 may include an opaque material. For example, the pixel defining layer 370 may include a white organic material such as zirconium oxide (ZrOx) and/or a titanium oxide (TiOx). Therefore, the pixel defining layer 370 may block light due to reflection by metal wirings. The pixel defining layer 370 may block light incident to the light-emitting region II, and thus blurring of images may be prevented or reduced.

However, exemplary embodiments are not limited thereto. For example, the pixel defining layer 370 may include organic materials of various colors such as an opaque organic material having a red color, a green color, or a blue color.

The emission layer 390 may be disposed on the first electrode 350 which is exposed via the first opening of the pixel defining layer 370. The emission layer 390 may be formed using light emitting materials capable of generating different colors of light (e.g., a red color of light, a blue color of light, and a green color of light). However, in some exemplary embodiments, the emission layer 390 may generally generate a white color of light by stacking a plurality of light emitting materials capable of generating different colors of light such as a red color of light, a green color of light, a blue color of light, etc.

Referring back to FIG. 2, a second electrode 410 is formed on the substrate 100 on which the pixel defining layer 370 is formed.

The second electrode 410 may be disposed on the pixel defining layer 370, the emission layer 390, and the first insulating layer 250. For example, the second electrode 410 may be disposed to have a substantially uniform thickness along a profile of the pixel defining layer 370, the emission layer 390, and the first insulating layer 250. The second electrode 410 may contact a portion of the first insulating layer 250 via the second opening of the pixel defining layer 370, and may extend into the transparent region III. That is, the second electrode 410 may extend into the second opening. In exemplary embodiments, the second electrode 410 may include a transparent conductive material. For example, the second electrode 410 may include at least one of ITO, SnOx, InOx, GaOx, IZO, etc. Thus, the second electrode 410 positioned in the transparent region III may not substantially reduce transmittivity of the transparent region III. In some exemplary embodiments, the second electrode 410 may include materials substantially the same as that of the first electrode 350.

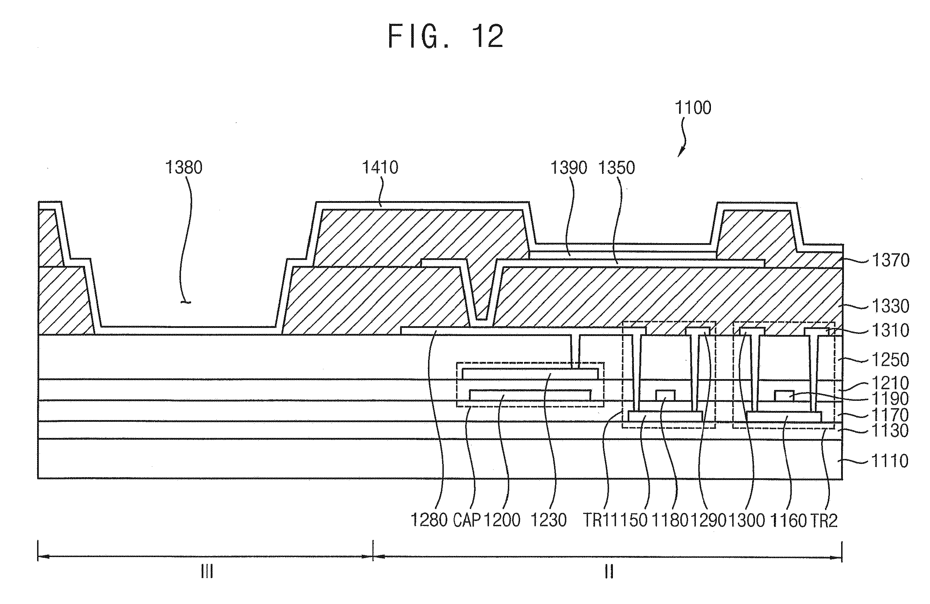

FIG. 12 is a cross-sectional view illustrating an organic light emitting display device according to an exemplary embodiment.

An organic light emitting display device 1100 according to the exemplary embodiment shown in FIG. 12 is substantially same as the organic light emitting display device 100 of FIGS. 1 to 11 except for a second insulating layer 1330, and thus repetitive explanation will be omitted.

Referring to FIG. 12, the second insulating layer 1330 may cover the first source electrode, the first drain electrode 1290, the second source electrode 1300, and the second drain electrode 1310. The second insulating layer 1330 may be disposed such that the second insulating layer 1330 is overlapped with a portion of the power supply electrode 1280. That is, at least a portion of the power supply electrode 1280 may be exposed by the second insulating layer 1330.

The second insulating layer 1330 may include an inorganic material or an organic material used alone or in a combination thereof. The second insulating layer 1330 may include an opaque material. The second insulating layer 1330 may include may include a white organic material such as zirconium oxide (ZrOx) and/or titanium oxide (TiOx). In this manner, the second insulating layer 1330 may block light due to reflection by metal wirings. The second insulating layer 1330 may block light incident to the light-emitting region II, and thus blurring of images may be prevented or reduced.

The first electrode 1350 may include at least one of metal, alloy, metal nitride, conductive metal oxide, a transparent conductive material, etc. For example, the first electrode 1350 may include at least one of aluminum (Al), aluminum alloy, aluminum nitride (AlNx), silver (Ag), silver alloy, tungsten (W), tungsten nitride (WNx), copper (Cu), copper alloy, nickel (Ni), chromium (Cr), chromium nitride (CrNx), molybdenum (Mo), molybdenum alloy, titanium (Ti), titanium nitride (TiNx), platinum (Pt), tantalum (Ta), tantalum nitride (TaNx), neodymium (Nd), scandium (Sc), strontium ruthenium oxide (SRO), zinc oxide (ZnOx), indium tin oxide (ITO), tin oxide (SnOx), indium oxide (InOx), gallium oxide (GaOx), indium zinc oxide (IZO), etc.

The pixel defining layer 1370 may be disposed on the first electrode 1350, a portion of the second insulating layer 1330, and a portion of the first insulating layer 1250. The pixel defining layer 1370 may include a first opening and a second opening. In the light-emitting region II, the first opening of the pixel defining layer 1370 may be positioned in a portion of the first electrode 1350 disposed on the second insulating layer 1330. The emission layer 1390 may be disposed in the first opening. The second opening of the pixel defining layer 1370 may be positioned in the transparent region III. The second opening may be defined as the transparent window 1380. The pixel defining layer 1370 may include organic materials or inorganic materials used alone or in a combination thereof. In some exemplary embodiments, the pixel defining layer 1370 may include materials substantially the same as that of the second insulating layer 1330.

In the exemplary embodiment shown in FIG. 12, the pixel defining layer 1370 may include an opaque material. For example, the pixel defining layer 1370 may include a white organic material such as zirconium oxide (ZrOx) or a titanium oxide (TiOx). Therefore, the pixel defining layer 1370 may block light due to reflection by metal wirings. The pixel defining layer 1370 may block light incident to the light-emitting region II, and thus blurring of images may be prevented or reduced.

However, exemplary embodiments are not limited thereto. For example, the pixel defining layer 1370 may include organic materials of various colors, such as an opaque organic material having a red color, a green color, or a blue color.

The emission layer 1390 may be disposed on the first electrode 1350 which is exposed via the first opening of the pixel defining layer 1370. The emission layer 1390 may be formed using light emitting materials capable of generating different colors of light (e.g., a red color of light, a blue color of light, and a green color of light). In some exemplary embodiments, the emission layer 1390 may generally generate a white color of light by stacking a plurality of light emitting materials capable of generating different colors of light such as a red color of light, a green color of light, a blue color of light, etc.

The second electrode 1410 may be disposed on the pixel defining layer 1370, the emission layer 1390, and the first insulating layer 1250. For example, the second electrode 1410 may be disposed to have a substantially uniform thickness along a profile of the pixel defining layer 1370, the emission layer 1390, and the first insulating layer 1250. The second electrode 1410 may contact a portion of the first insulating layer 1250 via the second opening of the pixel defining layer 1370, and may extend into the transparent region III. That is, the second electrode 1410 may extend into the second opening. In exemplary embodiments, the second electrode 1410 may include a transparent conductive material. For example, the second electrode 1410 may include ITO, SnOx, InOx, GaOx, IZO, etc. Thus, the second electrode 1410 positioned in the transparent region III may not substantially reduce transmittivity of the transparent region III. In some exemplary embodiments, the second electrode 1410 may include materials substantially the same as that of the first electrode 1350.

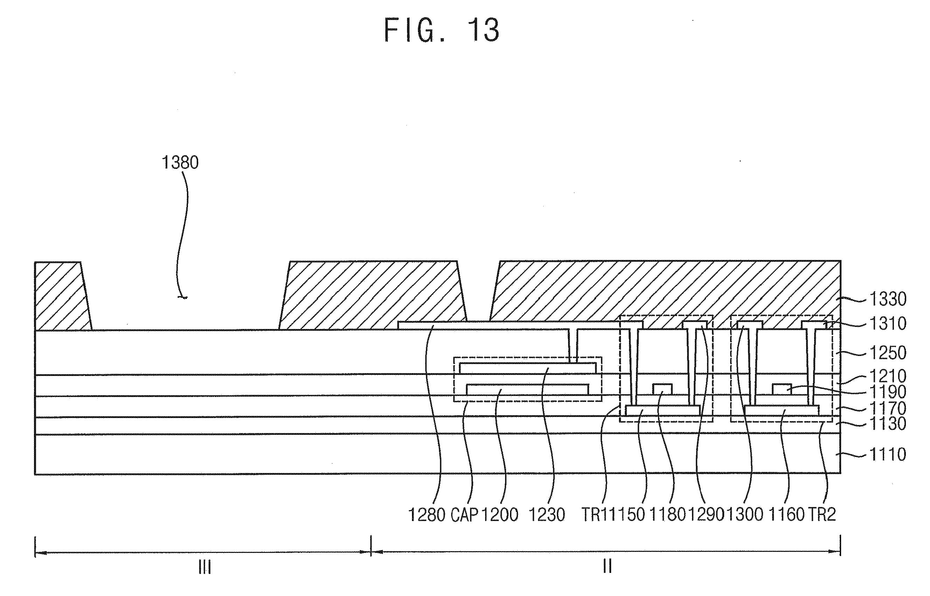

FIGS. 13 to 15 are cross-sectional views illustrating a method of manufacturing the organic light emitting display device of FIG. 12.

Referring to FIG. 13, a second insulating layer 1330 is formed on the substrate 1110 on which the first source electrode (connected to power supply electrode 1280), the first drain electrode 1290, the second source electrode 1300, the second drain electrode 1310, and the power supply electrode 1280 are formed. Thereafter, the second insulating layer 1330 is patterned to form a transparent window 1380 and a contact hole.

The second insulating layer 1330 may cover the first source electrode, the first drain electrode 1290, the second source electrode 1300, and the second drain electrode 1310. The second insulating layer 1330 may be disposed such that the second insulating layer 1330 is overlapped with a portion of the power supply electrode 1280. That is, at least a portion of the power supply electrode 1280 may be exposed by the second insulating layer 1330.

The second insulating layer 1330 may include an inorganic material or an organic material used alone or in a combination thereof. The second insulating layer 1330 may include an opaque material. The second insulating layer 1330 may include may include a white organic material such as zirconium oxide (ZrOx) and/or titanium oxide (TiOx). In this manner, the second insulating layer 1330 may block light due to reflection by metal wirings. The second insulating layer 1330 may block light incident to the light-emitting region II, and thus blurring of images may be prevented or reduced.

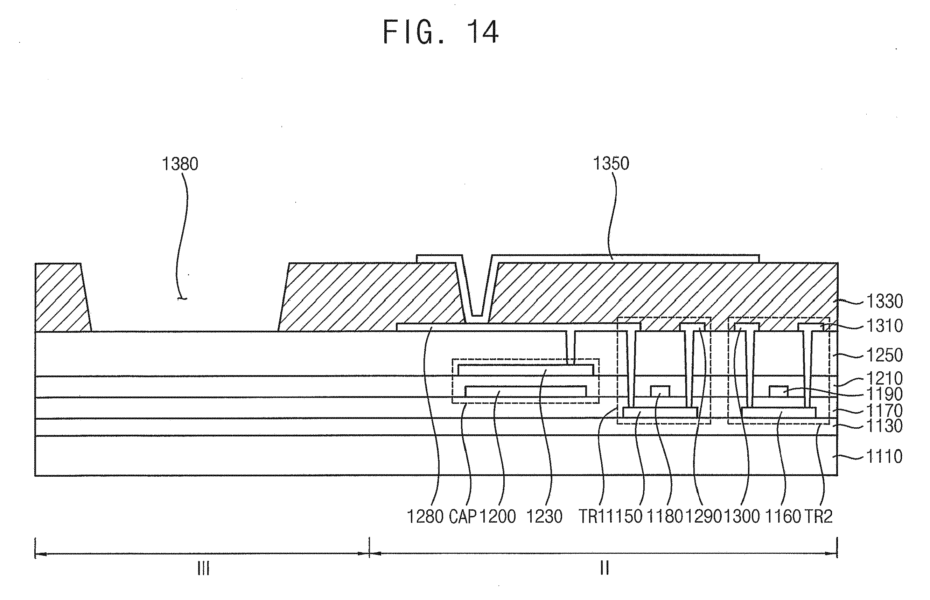

Referring to FIG. 14, a first electrode 1350 is formed on the second insulating layer 1330.

The first electrode 1350 may be disposed on a portion of the first insulating layer 1250, a portion of the power supply electrode 1280, and a portion of the second insulating layer 1330 in the light-emitting region II. In exemplary embodiments, the first electrode 1350 may be disposed to have a substantially uniform thickness along a profile of the power supply electrode 1280 and the second insulating layer 1330.

The first electrode 1350 may include at least one of metal, alloy, metal nitride, conductive metal oxide, a transparent conductive material, etc. For example, the first electrode 1350 may include at least one of aluminum (Al), aluminum alloy, aluminum nitride (AlNx), silver (Ag), silver alloy, tungsten (W), tungsten nitride (WNx), copper (Cu), copper alloy, nickel (Ni), chromium (Cr), chromium nitride (CrNx), molybdenum (Mo), molybdenum alloy, titanium (Ti), titanium nitride (TiNx), platinum (Pt), tantalum (Ta), tantalum nitride (TaNx), neodymium (Nd), scandium (Sc), strontium ruthenium oxide (SRO), zinc oxide (ZnOx), indium tin oxide (ITO), tin oxide (SnOx), indium oxide (InOx), gallium oxide (GaOx), indium zinc oxide (IZO), etc.

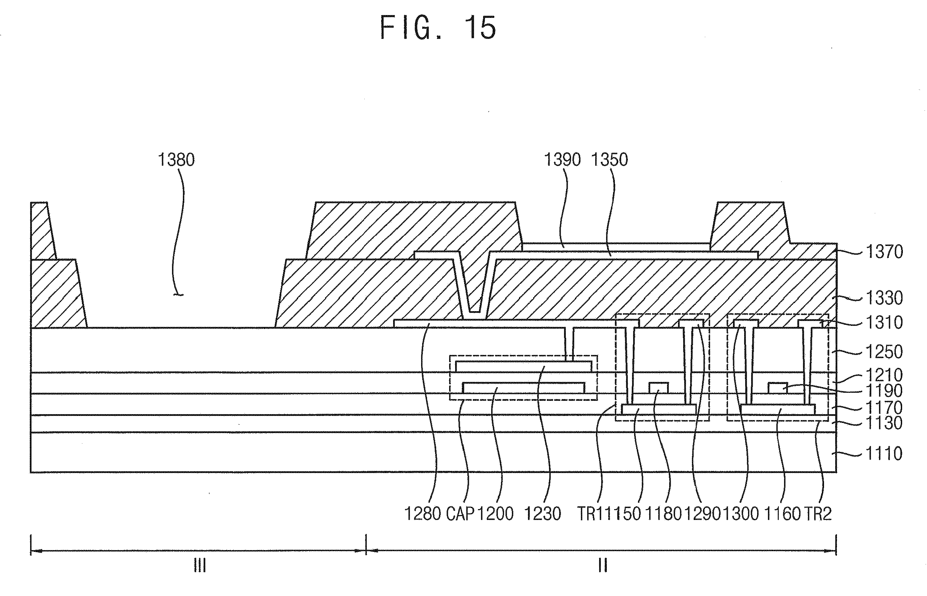

Referring to FIG. 15, a pixel defining layer 1370 is formed on the substrate 1110 on which the first electrode 1350 is formed. Thereafter, an emission layer 1390 is formed on the first electrode 1350 which is exposed via the first opening of the pixel defining layer 1370.

The pixel defining layer 1370 may be disposed on the first electrode 1350, a portion of the second insulating layer 1330, and a portion of the first insulating layer 1250. The pixel defining layer 1370 may include a first opening and a second opening. In the light-emitting region II, the first opening of the pixel defining layer 1370 may be positioned in a portion of the first electrode 1350 disposed on the second insulating layer 1330. The emission layer 1390 may be disposed in the first opening. The second opening of the pixel defining layer 1370 may be positioned in the transparent region III. The second opening may be defined as the transparent window 1380. The pixel defining layer 1370 may include organic materials or inorganic materials used alone or in a combination thereof. In some exemplary embodiments, the pixel defining layer 1370 may include materials substantially the same as that of the second insulating layer 1330.

In the exemplary embodiment shown in FIG. 15, the pixel defining layer 1370 may include an opaque material. For example, the pixel defining layer 1370 may include a white organic material such as zirconium oxide (ZrOx) and/or titanium oxide (TiOx). In this manner, the pixel defining layer 1370 may block light due to reflection by metal wirings. The pixel defining layer 1370 may block light incident to the light-emitting region II, and thus blurring of images may be prevented or reduced.

However, exemplary embodiments are not limited thereto. The pixel defining layer 1370 may include organic materials of various colors such as an opaque organic material having a red color, a green color, or a blue color.

The emission layer 1390 may be disposed on the first electrode 1350 which is exposed via the first opening of the pixel defining layer 1370. The emission layer 1390 may be formed using light emitting materials capable of generating different colors of light (e.g., a red color of light, a blue color of light, and a green color of light). However, in some exemplary embodiments, the emission layer 1390 may generally generate a white color of light by stacking a plurality of light emitting materials capable of generating different colors of light such as a red color of light, a green color of light, a blue color of light, etc.

Referring back to FIG. 12, a second electrode 1410 is formed on the substrate 1100 on which the pixel defining layer 1370 is formed.

The second electrode 1410 may be disposed on the pixel defining layer 1370, the emission layer 1390, and the first insulating layer 1250. For example, the second electrode 1410 may be disposed having a substantially uniform thickness along a profile of the pixel defining layer 1370, the emission layer 1390, and the first insulating layer 1250. The second electrode 1410 may contact a portion of the first insulating layer 1250 via the second opening of the pixel defining layer 1370, and may extend into the transparent region III. That is, the second electrode 1410 may extend into the second opening. In exemplary embodiments, the second electrode 1410 may include a transparent conductive material. For example, the second electrode 1410 may include ITO, SnOx, InOx, GaOx, IZO, etc. Thus, the second electrode 1410 positioned in the transparent region III may not substantially reduce transmittivity of the transparent region III. In some exemplary embodiments, the second electrode 1410 may include materials substantially the same as that of the first electrode 1350.

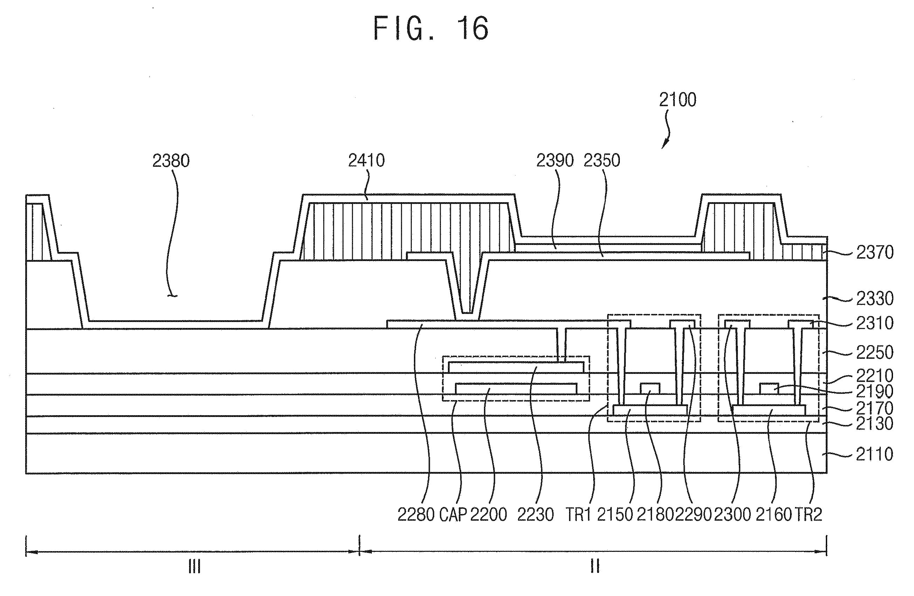

FIG. 16 is a cross-sectional view illustrating an organic light emitting display device according to an exemplary embodiment.

An organic light emitting display device 2100 according to the exemplary embodiment shown in FIG. 16 is substantially same as the organic light emitting display device 100 of FIGS. 1 to 11 except for a pixel defining layer 2370, and thus repetitive explanation will be omitted.

Referring to FIG. 16, the pixel defining layer 2370 may be disposed on the first electrode 2350, a portion of the second insulating layer 2330, and a portion of the first insulating layer 2250. The pixel defining layer 2370 may include a first opening and a second opening. In the light-emitting region II, the first opening of the pixel defining layer 2370 may be positioned in a portion of the first electrode 2350 disposed on the second insulating layer 2330. The emission layer 2390 may be disposed in the first opening. The second opening of the pixel defining layer 2370 may be positioned in the transparent region III. The second opening may be defined as the transparent window 2380. The pixel defining layer 2370 may include organic materials or inorganic materials used alone or in a combination thereof. In some exemplary embodiments, the pixel defining layer 2370 may include materials substantially the same as that of the second insulating layer 2330.

In the exemplary embodiment shown in FIG. 16, the pixel defining layer 2370 may include an opaque material. For example, the pixel defining layer 2370 may include a black organic material, such as carbon or cobalt. Therefore, the pixel defining layer 2370 may block light due to reflection by metal wirings. The pixel defining layer 2370 may block light incident to the light-emitting region II, and thus blurring of images may be prevented or reduced.

The emission layer 2390 may be disposed on the first electrode 2350 which is exposed via the first opening of the pixel defining layer 2370. The emission layer 2390 may be formed using light emitting materials capable of generating different colors of light (e.g., a red color of light, a blue color of light, and a green color of light). However, in some exemplary embodiments, the emission layer 2390 may generally generate a white color of light by stacking a plurality of light emitting materials capable of generating different colors of light such as a red color of light, a green color of light, a blue color of light, etc.

The second electrode 2410 may be disposed on the pixel defining layer 2370, the emission layer 2390, and the first insulating layer 2250. For example, the second electrode 2410 may be disposed to have a substantially uniform thickness along a profile of the pixel defining layer 2370, the emission layer 2390, and the first insulating layer 2250. The second electrode 2410 may contact a portion of the first insulating layer 2250 via the second opening of the pixel defining layer 2370, and may extend into the transparent region III. That is, the second electrode 2410 may extend into the second opening. In exemplary embodiments, the second electrode 2410 may include a transparent conductive material. For example, the second electrode 2410 may include ITO, SnOx, InOx, GaOx, IZO, etc. Thus, the second electrode 2410 positioned in the transparent region III may not substantially reduce transmittivity of the transparent region III. In some exemplary embodiments, the second electrode 2410 may include materials substantially the same as that of the first electrode 2350.

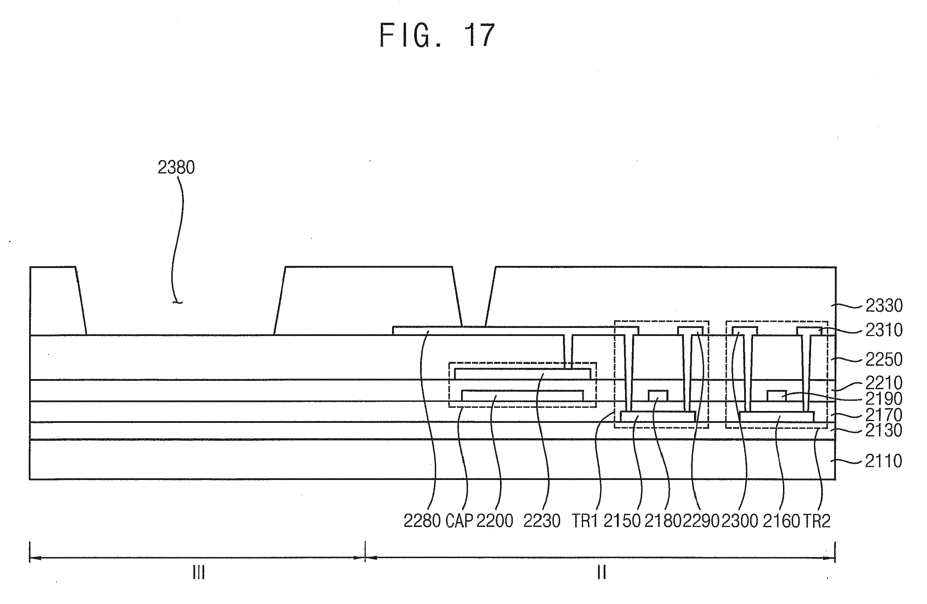

FIGS. 17 to 19 are cross-sectional views illustrating a method of manufacturing the organic light emitting display device of FIG. 16.

Referring to FIG. 17, a second insulating layer 2330 is formed on the substrate 2110 on which the first source electrode, the first drain electrode 2290, the second source electrode 2300, the second drain electrode 2310 and the power supply electrode 2280 are formed. Thereafter, the second insulating layer 2330 is patterned to form a transparent window 2380 and a contact hole.

The second insulating layer 2330 may cover the first source electrode (connected to power supply electrode 2280), the first drain electrode 2290, the second source electrode 2300, and the second drain electrode 2310. The second insulating layer 2330 may be disposed such that the second insulating layer 2330 is overlapped with a portion of the power supply electrode 2280. That is, at least a portion of the power supply electrode 2280 may be exposed by the second insulating layer 2330.

The second insulating layer 2330 may include an inorganic material. For example, the second insulating layer 2330 may include at least one of a silicon compound such as silicon oxide (SiOx), silicon nitride (SiNx), silicon oxynitride (SiOxNy), silicon oxycarbide (SiOxCy), silicon carbonitride (SiCxNy), etc. In some exemplary embodiments, the second insulating layer 2330 may include an organic material. For example, the second insulating layer 2330 may include at least one of polyimide-based resin, photoresist, acrylic-based resin, polyamide-based resin, siloxane-based resin, etc.

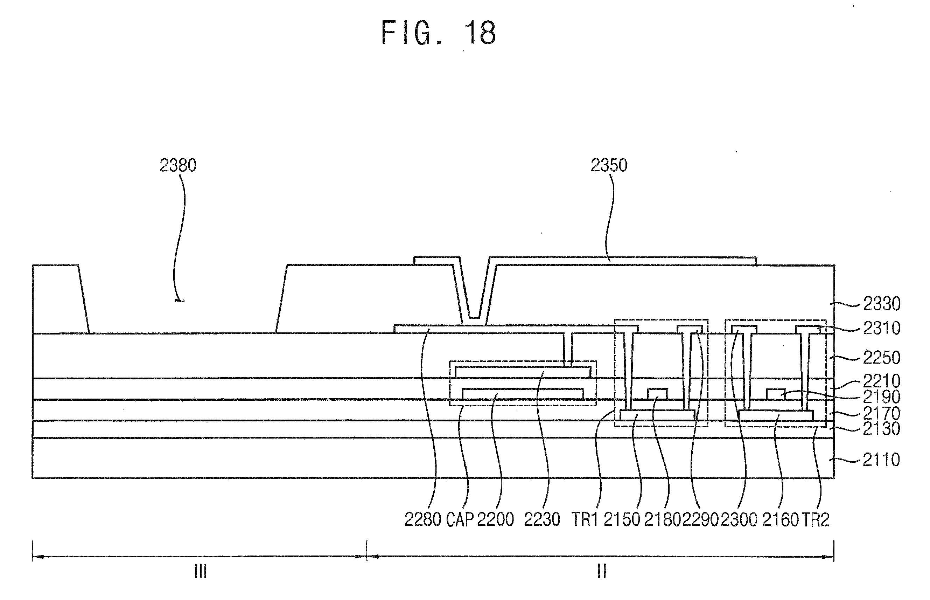

Referring to FIG. 18, a first electrode 2350 is formed on the second insulating layer 2330.

The first electrode 2350 may be disposed on a portion of the first insulating layer 2250, a portion of the power supply electrode 2280, and a portion of the second insulating layer 2330 in the light-emitting region II. In exemplary embodiments, the first electrode 2350 may be disposed to have a substantially uniform thickness along a profile of the power supply electrode 2280 and the second insulating layer 2330.

The first electrode 2350 may include at least one of metal, alloy, metal nitride, conductive metal oxide, a transparent conductive material, etc. For example, the first electrode 2350 may include at least one of aluminum (Al), aluminum alloy, aluminum nitride (AlNx), silver (Ag), silver alloy, tungsten (W), tungsten nitride (WNx), copper (Cu), copper alloy, nickel (Ni), chromium (Cr), chromium nitride (CrNx), molybdenum (Mo), molybdenum alloy, titanium (Ti), titanium nitride (TiNx), platinum (Pt), tantalum (Ta), tantalum nitride (TaNx), neodymium (Nd), scandium (Sc), strontium ruthenium oxide (SRO), zinc oxide (ZnOx), indium tin oxide (ITO), tin oxide (SnOx), indium oxide (InOx), gallium oxide (GaOx), indium zinc oxide (IZO), etc.

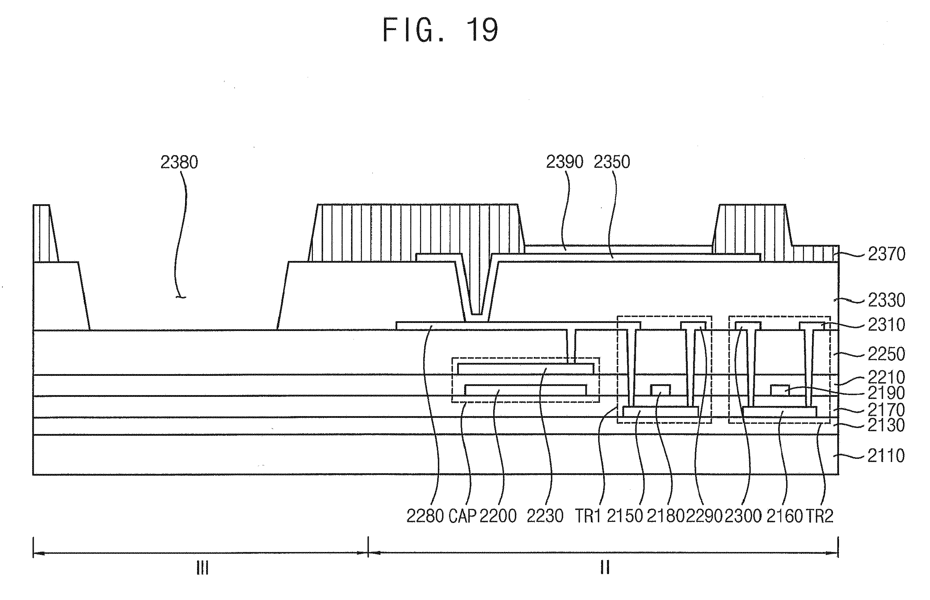

Referring to FIG. 19, a pixel defining layer 2370 is formed on the substrate 2110 on which the first electrode 2350 is formed. Thereafter, an emission layer 2390 is formed on the first electrode 2350 which is exposed via the first opening of the pixel defining layer 2370.

The pixel defining layer 2370 may be disposed on the first electrode 2350, a portion of the second insulating layer 2330, and a portion of the first insulating layer 2250. The pixel defining layer 2370 may include a first opening and a second opening. In the light-emitting region II, the first opening of the pixel defining layer 2370 may be positioned in a portion of the first electrode 2350 disposed on the second insulating layer 2330. The emission layer 2390 may be disposed in the first opening. The second opening of the pixel defining layer 2370 may be positioned in the transparent region III. The second opening may be defined as the transparent window 2380. The pixel defining layer 2370 may include organic materials or inorganic materials used alone or in a combination thereof. In some exemplary embodiments, the pixel defining layer 2370 may include materials substantially the same as that of the second insulating layer 2330.

In the exemplary embodiment shown in FIG. 19, the pixel defining layer 2370 may include an opaque material. For example, the pixel defining layer 2370 may include a black organic material such as carbon or cobalt. In this manner, the pixel defining layer 2370 may block light due to reflection by metal wirings. The pixel defining layer 2370 may block light incident to the light-emitting region II, and thus blurring of images may be prevented or reduced.

However, exemplary embodiments are not limited thereto. The pixel defining layer 2370 may include organic materials of various colors such as an opaque organic material having a red color, a green color, or a blue color.

The emission layer 2390 may be disposed on the first electrode 2350 which is exposed via the first opening of the pixel defining layer 2370. The emission layer 2390 may be formed using light emitting materials capable of generating different colors of light (e.g., a red color of light, a blue color of light, and a green color of light). However, in some exemplary embodiments, the emission layer 2390 may generally generate a white color of light by stacking a plurality of light emitting materials capable of generating different colors of light such as a red color of light, a green color of light, a blue color of light, etc.

Referring back to FIG. 16, a second electrode 2410 is formed on the substrate 2100 on which the pixel defining layer 2370 is formed.

The second electrode 2410 may be disposed on the pixel defining layer 2370, the emission layer 2390, and the first insulating layer 2250. The second electrode 2410 may be disposed to have a substantially uniform thickness along a profile of the pixel defining layer 2370, the emission layer 2390, and the first insulating layer 2250. The second electrode 2410 may contact a portion of the first insulating layer 2250 via the second opening of the pixel defining layer 2370, and may extend into the transparent region III. That is, the second electrode 2410 may extend into the second opening. In exemplary embodiments, the second electrode 2410 may include a transparent conductive material. For example, the second electrode 2410 may include ITO, SnOx, InOx, GaOx, IZO, etc. Thus, the second electrode 2410 positioned in the transparent region III may not substantially reduce transmittivity of the transparent region III. In some exemplary embodiments, the second electrode 2410 may include materials substantially the same as that of the first electrode 2350.

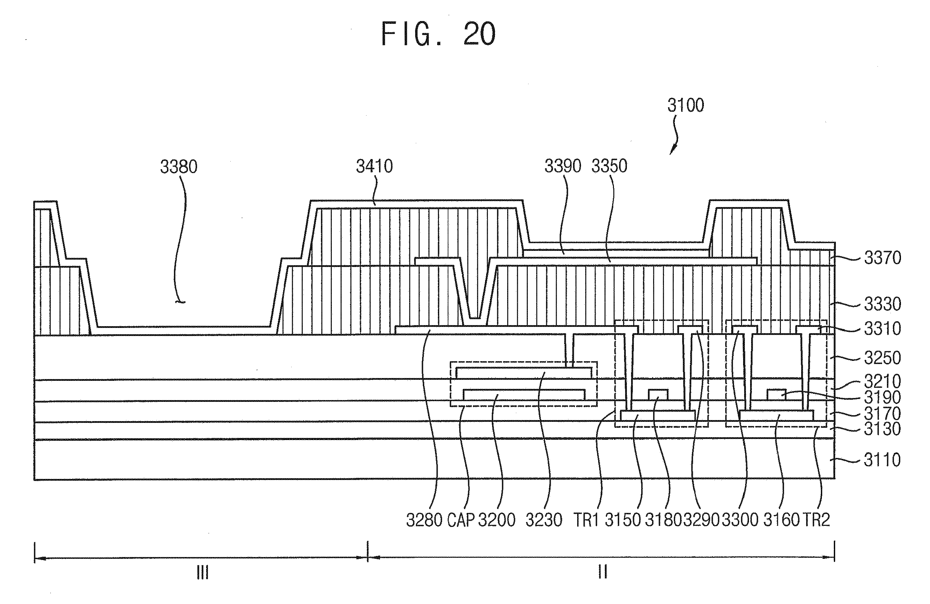

FIG. 20 is a cross-sectional view illustrating an organic light emitting display device according to an exemplary embodiment.

An organic light emitting display device 3100 according to the present example embodiment is substantially same as the organic light emitting display device 100 of FIGS. 1 to 11 except for a second insulating layer 3330 and a pixel defining layer 3370, and thus repetitive explanation will be omitted.

Referring to FIG. 20, the second insulating layer 3330 may cover the first source electrode, the first drain electrode 3290, the second source electrode 3300, and the second drain electrode 3310. The second insulating layer 3330 may be disposed such that the second insulating layer 3330 is overlapped with a portion of the power supply electrode 3280. That is, at least a portion of the power supply electrode 3280 may be exposed by the second insulating layer 3330.

The second insulating layer 3330 may include an inorganic material or an organic material used alone or in a combination thereof. The second insulating layer 3330 may include an opaque material. The second insulating layer 3330 may include may include a black organic material such as carbon or cobalt. In this manner, the second insulating layer 3330 may block light due to reflection by metal wirings. The second insulating layer 3330 may block light incident to the light-emitting region II, and thus blurring of images may be prevented or reduced.

The first electrode 3350 may include at least one of metal, alloy, metal nitride, conductive metal oxide, a transparent conductive material, etc. For example, the first electrode 3350 may include at least one of aluminum (Al), aluminum alloy, aluminum nitride (AlNx), silver (Ag), silver alloy, tungsten (W), tungsten nitride (WNx), copper (Cu), copper alloy, nickel (Ni), chromium (Cr), chromium nitride (CrNx), molybdenum (Mo), molybdenum alloy, titanium (Ti), titanium nitride (TiNx), platinum (Pt), tantalum (Ta), tantalum nitride (TaNx), neodymium (Nd), scandium (Sc), strontium ruthenium oxide (SRO), zinc oxide (ZnOx), indium tin oxide (ITO), tin oxide (SnOx), indium oxide (InOx), gallium oxide (GaOx), indium zinc oxide (IZO), etc.

The pixel defining layer 3370 may be disposed on the first electrode 3350, a portion of the second insulating layer 3330, and a portion of the first insulating layer 3250. The pixel defining layer 3370 may include a first opening and a second opening. In the light-emitting region II, the first opening of the pixel defining layer 3370 may be positioned in a portion of the first electrode 3350 disposed on the second insulating layer 3330. The emission layer 3390 may be disposed in the first opening. The second opening of the pixel defining layer 3370 may be positioned in the transparent region III. The second opening may be defined as the transparent window 3380. The pixel defining layer 3370 may include organic materials or inorganic materials used alone or in a combination thereof. In some exemplary embodiments, the pixel defining layer 3370 may include materials substantially the same as that of the second insulating layer 3330.

In the exemplary embodiment shown in FIG. 20, the pixel defining layer 3370 may include an opaque material. For example, the pixel defining layer 3370 may include a black organic material such as carbon or cobalt. In this manner, the pixel defining layer 3370 may block light due to reflection by metal wirings. The pixel defining layer 3370 may block light incident to the light-emitting region II, and thus blurring of images may be prevented or reduced.

However, the exemplary embodiments are not limited thereto. The pixel defining layer 3370 may include organic materials of various colors. For example, the pixel defining layer 3370 may include an opaque organic material having a red color, a green color, or a blue color.

The emission layer 3390 may be disposed on the first electrode 3350 which is exposed via the first opening of the pixel defining layer 3370. The emission layer 3390 may be formed using light emitting materials capable of generating different colors of light (e.g., a red color of light, a blue color of light, and a green color of light). However, in some exemplary embodiments, the emission layer 3390 may generally generate a white color of light by stacking a plurality of light emitting materials capable of generating different colors of light such as a red color of light, a green color of light, a blue color of light, etc.

The second electrode 3410 may be disposed on the pixel defining layer 3370, the emission layer 3390, and the first insulating layer 3250. The second electrode 3410 may be disposed to have a substantially uniform thickness along a profile of the pixel defining layer 3370, the emission layer 3390, and the first insulating layer 3250. The second electrode 3410 may contact a portion of the first insulating layer 3250 via the second opening of the pixel defining layer 3370, and may extend into the transparent region III. That is, the second electrode 3410 may extend into the second opening. In exemplary embodiments, the second electrode 3410 may include a transparent conductive material. For example, the second electrode 3410 may include ITO, SnOx, InOx, GaOx, IZO, etc. Thus, the second electrode 3410 positioned in the transparent region III may not substantially reduce transmittivity of the transparent region III. In some exemplary embodiments, the second electrode 3410 may include materials substantially the same as that of the first electrode 3350.

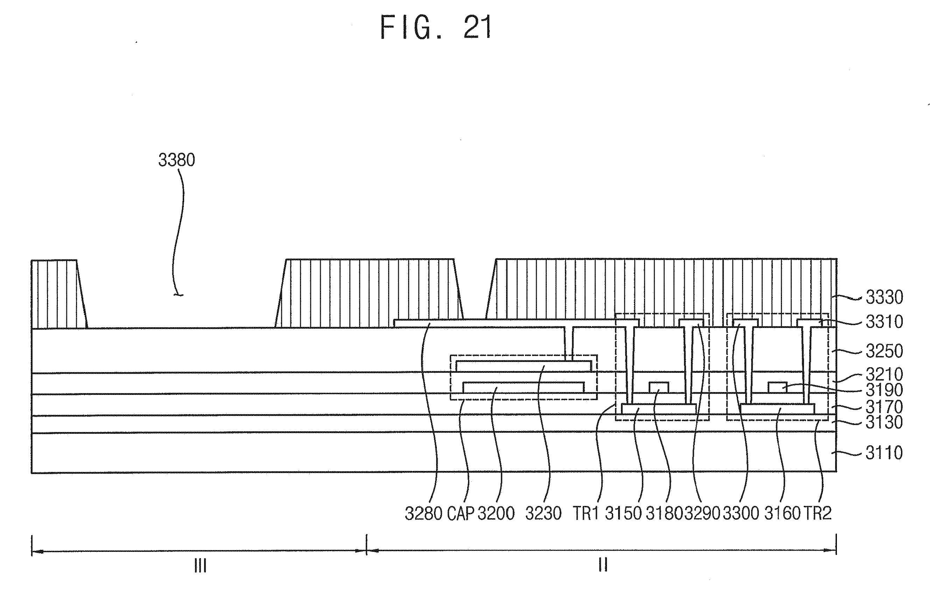

FIGS. 21 to 23 are cross-sectional views illustrating a method of manufacturing the organic light emitting display device of FIG. 20.

Referring to FIG. 21, a second insulating layer 3330 is formed on the substrate 3110 on which the first source electrode (connected to power supply electrode 3280), the first drain electrode 3290, the second source electrode 1300, the second drain electrode 3310, and the power supply electrode 3280 are formed. Thereafter, the second insulating layer 3330 is patterned to form a transparent window 3380 and a contact hole.

The second insulating layer 3330 may cover the first source electrode, the first drain electrode 3290, the second source electrode 3300, and the second drain electrode 3310. The second insulating layer 3330 may be disposed such that the second insulating layer 3330 is overlapped with a portion of the power supply electrode 3280. That is, at least a portion of the power supply electrode 3280 may be exposed by the second insulating layer 3330.

The second insulating layer 3330 may include an inorganic material or an organic material used alone or in a combination thereof. The second insulating layer 3330 may include an opaque material. The second insulating layer 3330 may include may include a black organic material such as carbon or cobalt. In this manner, the second insulating layer 3330 may block light due to reflection by metal wirings. The second insulating layer 3330 may block light incident to the light-emitting region II, and thus blurring of images may be prevented or reduced.

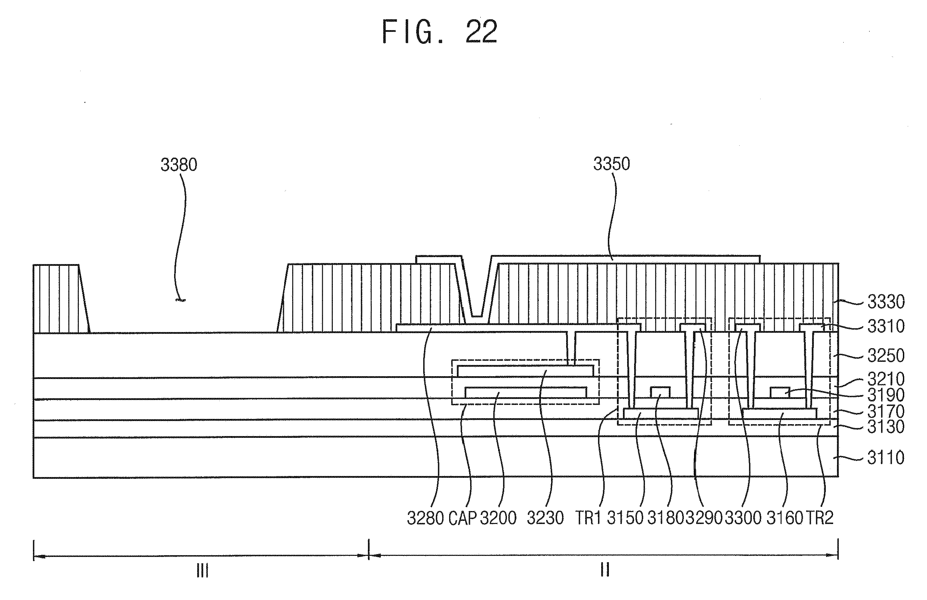

Referring to FIG. 22, a first electrode 3350 is formed on the second insulating layer 3330.

The first electrode 3350 may be disposed on a portion of the first insulating layer 3250, a portion of the power supply electrode 3280, and a portion of the second insulating layer 3330 in the light-emitting region II. In exemplary embodiments, the first electrode 3350 may be disposed to have a substantially uniform thickness along a profile of the power supply electrode 3280 and the second insulating layer 3330.

The first electrode 3350 may include at least one of metal, alloy, metal nitride, conductive metal oxide, a transparent conductive material, etc. For example, the first electrode 3350 may include at least one of aluminum (Al), aluminum alloy, aluminum nitride (AlNx), silver (Ag), silver alloy, tungsten (W), tungsten nitride (WNx), copper (Cu), copper alloy, nickel (Ni), chromium (Cr), chromium nitride (CrNx), molybdenum (Mo), molybdenum alloy, titanium (Ti), titanium nitride (TiNx), platinum (Pt), tantalum (Ta), tantalum nitride (TaNx), neodymium (Nd), scandium (Sc), strontium ruthenium oxide (SRO), zinc oxide (ZnOx), indium tin oxide (ITO), tin oxide (SnOx), indium oxide (InOx), gallium oxide (GaOx), indium zinc oxide (IZO), etc.

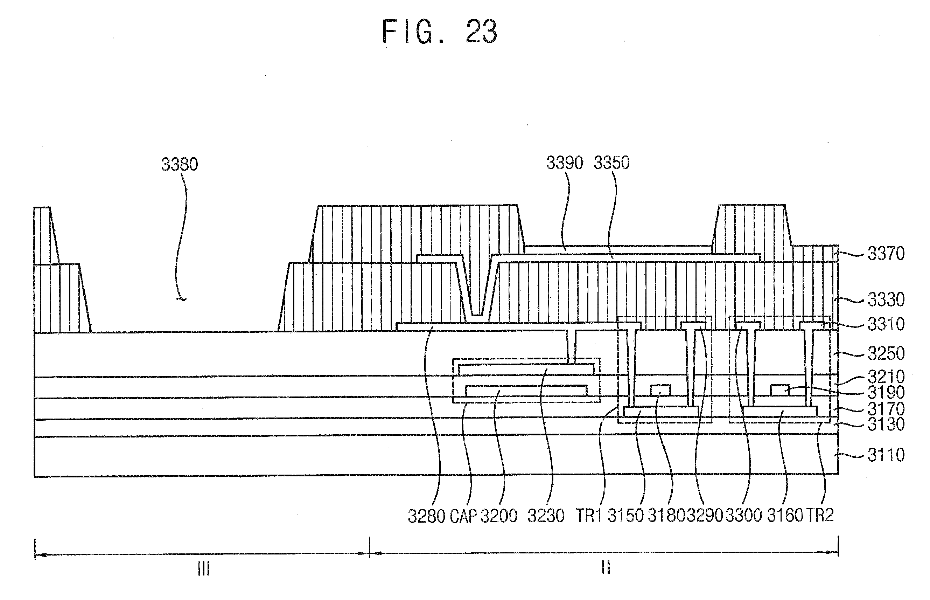

Referring to FIG. 23, a pixel defining layer 3370 is formed on the substrate 3110 on which the first electrode 3350 is formed. Thereafter, an emission layer 3390 is formed on the first electrode 3350 which is exposed via the first opening of the pixel defining layer 3370.

The pixel defining layer 3370 may be disposed on the first electrode 3350, a portion of the second insulating layer 3330, and a portion of the first insulating layer 3250. The pixel defining layer 3370 may include a first opening and a second opening. In the light-emitting region II, the first opening of the pixel defining layer 3370 may be positioned in a portion of the first electrode 3350 disposed on the second insulating layer 3330. The emission layer 3390 may be disposed in the first opening. The second opening of the pixel defining layer 3370 may be positioned in the transparent region III. The second opening may be defined as the transparent window 3380. The pixel defining layer 3370 may include organic materials or inorganic materials used alone or in a combination thereof. In some exemplary embodiments, the pixel defining layer 3370 may include materials substantially the same as that of the second insulating layer 3330.

In the exemplary embodiments shown in FIG. 23, the pixel defining layer 3370 may include an opaque material. For example, the pixel defining layer 3370 may include a black organic material, such as carbon or cobalt. Therefore, the pixel defining layer 3370 may block light due to reflection by metal wirings. The pixel defining layer 3370 may block light incident to the light-emitting region II, and thus blurring of images may be prevented or reduced.

However, exemplary embodiments are not limited thereto. For example, the pixel defining layer 3370 may include organic materials of various colors. For example, the pixel defining layer 3370 may include an opaque organic material having a red color, a green color, or a blue color.

The emission layer 3390 may be disposed on the first electrode 3350 which is exposed via the first opening of the pixel defining layer 3370. The emission layer 3390 may be formed using light emitting materials capable of generating different colors of light (e.g., a red color of light, a blue color of light, and a green color of light). However, in some exemplary embodiments, the emission layer 3390 may generally generate a white color of light by stacking a plurality of light emitting materials capable of generating different colors of light such as a red color of light, a green color of light, a blue color of light, etc.

Referring back to FIG. 20, a second electrode 3410 is formed on the substrate 3100 on which the pixel defining layer 3370 is formed.

The second electrode 3410 may be disposed on the pixel defining layer 3370, the emission layer 3390, and the first insulating layer 3250. For example, the second electrode 3410 may be disposed to have a substantially uniform thickness along a profile of the pixel defining layer 3370, the emission layer 3390, and the first insulating layer 3250. The second electrode 3410 may contact a portion of the first insulating layer 3250 via the second opening of the pixel defining layer 3370, and may extend into the transparent region III. That is, the second electrode 3410 may extend into the second opening. In exemplary embodiments, the second electrode 3410 may include a transparent conductive material. For example, the second electrode 3410 may include ITO, SnOx, InOx, GaOx, IZO, etc. Thus, the second electrode 3410 positioned in the transparent region III may not substantially reduce transmittivity of the transparent region III. In some exemplary embodiments, the second electrode 3410 may include materials substantially the same as that of the first electrode 3350.

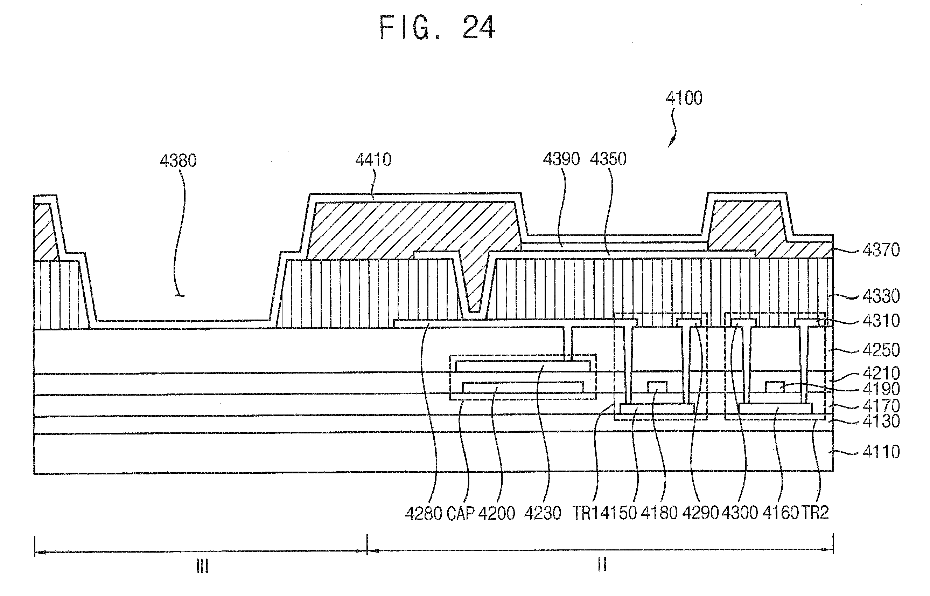

FIG. 24 is a cross-sectional view illustrating an organic light emitting display device according to an exemplary embodiment.

An organic light emitting display device 4100 according to the an exemplary embodiment is substantially same as the organic light emitting display device 100 of FIGS. 1 to 11 except for a second insulating layer 4330, and thus repetitive explanation will be omitted.

Referring to FIG. 24, the second insulating layer 4330 may cover the first source electrode (connected to power supply electrode 4280), the first drain electrode 4290, the second source electrode 4300, and the second drain electrode 4310. The second insulating layer 4330 may be disposed such that the second insulating layer 4330 is overlapped with a portion of the power supply electrode 4280. That is, at least a portion of the power supply electrode 4280 may be exposed by the second insulating layer 4330.

The second insulating layer 4330 may include an inorganic material or an organic material used alone or in a combination thereof. The second insulating layer 4330 may include an opaque material. The second insulating layer 4330 may include may include a black organic material, such as carbon or cobalt. In this manner, the second insulating layer 4330 may block light due to reflection by metal wirings. The second insulating layer 4330 may block light incident to the light-emitting region II, and thus blurring of images may be prevented or reduced.

The first electrode 4350 may include at least one of metal, alloy, metal nitride, conductive metal oxide, a transparent conductive material, etc. For example, the first electrode 4350 may include at least one of aluminum (Al), aluminum alloy, aluminum nitride (AlNx), silver (Ag), silver alloy, tungsten (W), tungsten nitride (WNx), copper (Cu), copper alloy, nickel (Ni), chromium (Cr), chromium nitride (CrNx), molybdenum (Mo), molybdenum alloy, titanium (Ti), titanium nitride (TiNx), platinum (Pt), tantalum (Ta), tantalum nitride (TaNx), neodymium (Nd), scandium (Sc), strontium ruthenium oxide (SRO), zinc oxide (ZnOx), indium tin oxide (ITO), tin oxide (SnOx), indium oxide (InOx), gallium oxide (GaOx), indium zinc oxide (IZO), etc.

The pixel defining layer 4370 may be disposed on the first electrode 4350, a portion of the second insulating layer 4330, and a portion of the first insulating layer 4250. The pixel defining layer 4370 may include a first opening and a second opening. In the light-emitting region II, the first opening of the pixel defining layer 4370 may be positioned in a portion of the first electrode 4350 disposed on the second insulating layer 4330. The emission layer 4390 may be disposed in the first opening. The second opening of the pixel defining layer 4370 may be positioned in the transparent region III. The second opening may be defined as the transparent window 4380. The pixel defining layer 4370 may include organic materials or inorganic materials used alone or in a combination thereof. In some exemplary embodiments, the pixel defining layer 4370 may include materials substantially the same as that of the second insulating layer 4330.

In the exemplary embodiment shown in FIG. 24, the pixel defining layer 4370 may include an opaque material. For example, the pixel defining layer 4370 may include a white organic material such as zirconium oxide (ZrOx) and/or titanium oxide (TiOx). In this manner, the pixel defining layer 4370 may block light due to reflection by metal wirings. The pixel defining layer 4370 may block light incident to the light-emitting region II, and thus blurring of images may be prevented or reduced.

However, exemplary embodiments are not limited thereto. For example, the pixel defining layer 4370 may include organic materials of various colors. For example, the pixel defining layer 4370 may include an opaque organic material having a red color, a green color, or a blue color.

The emission layer 4390 may be disposed on the first electrode 4350 which is exposed via the first opening of the pixel defining layer 4370. The emission layer 4390 may be formed using light emitting materials capable of generating different colors of light (e.g., a red color of light, a blue color of light, and a green color of light). However, in some exemplary embodiments, the emission layer 4390 may generally generate a white color of light by stacking a plurality of light emitting materials capable of generating different colors of light such as a red color of light, a green color of light, a blue color of light, etc.

The second electrode 4410 may be disposed on the pixel defining layer 4370, the emission layer 4390, and the first insulating layer 4250. For example, the second electrode 4410 may be disposed to have a substantially uniform thickness along a profile of the pixel defining layer 4370, the emission layer 4390, and the first insulating layer 4250. The second electrode 4410 may contact a portion of the first insulating layer 4250 via the second opening of the pixel defining layer 4370, and may extend into the transparent region III. That is, the second electrode 4410 may extend into the second opening. In exemplary embodiments, the second electrode 4410 may include a transparent conductive material. For example, the second electrode 4410 may include ITO, SnOx, InOx, GaOx, IZO, etc. Thus, the second electrode 4410 positioned in the transparent region III may not substantially reduce transmittivity of the transparent region III. In some exemplary embodiments, the second electrode 4410 may include materials substantially the same as that of the first electrode 4350.

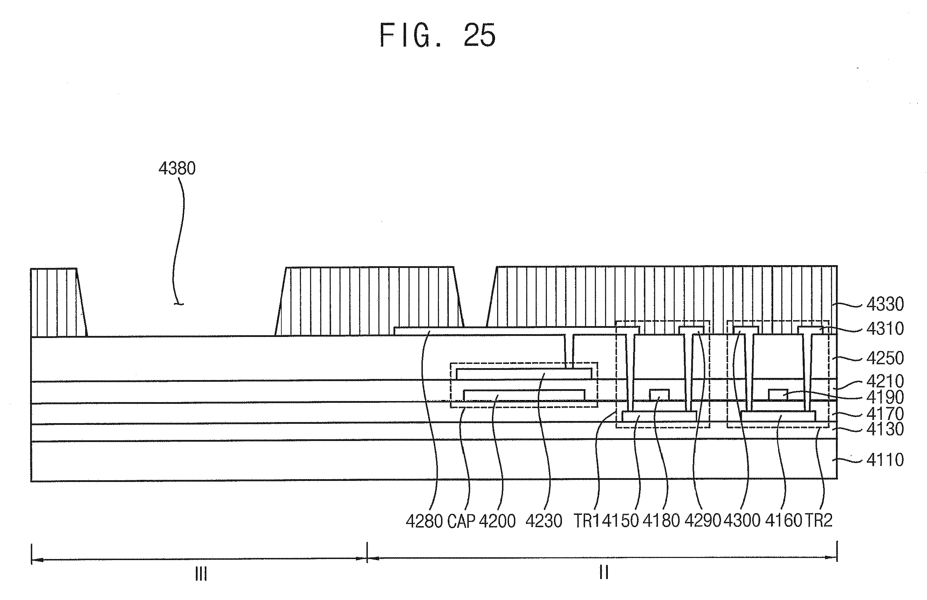

FIGS. 25 to 27 are cross-sectional views illustrating a method of manufacturing the organic light emitting display device of FIG. 24.

Referring to FIG. 25, a second insulating layer 4330 is formed on the substrate 4110 on which the first source electrode (connected to the power supply electrode 4280), the first drain electrode 4290, the second source electrode 4300, the second drain electrode 4310 and the power supply electrode 4280 are formed. Thereafter, the second insulating layer 4330 is patterned to form a transparent window 4380 and a contact hole.

The second insulating layer 4330 may cover the first source electrode, the first drain electrode 4290, the second source electrode 4300, and the second drain electrode 4310. The second insulating layer 4330 may be disposed such that the second insulating layer 4330 is overlapped with a portion of the power supply electrode 4280. That is, at least a portion of the power supply electrode 4280 may be exposed by the second insulating layer 4330.

The second insulating layer 4330 may include an inorganic material or an organic material used alone or in a combination thereof. The second insulating layer 4330 may include an opaque material. The second insulating layer 4330 may include may include a black organic material such as carbon or cobalt. Therefore, the second insulating layer 4330 may block light due to reflection by metal wirings. The second insulating layer 4330 may block light incident to the light-emitting region II, and thus blurring of images may be prevented or reduced.

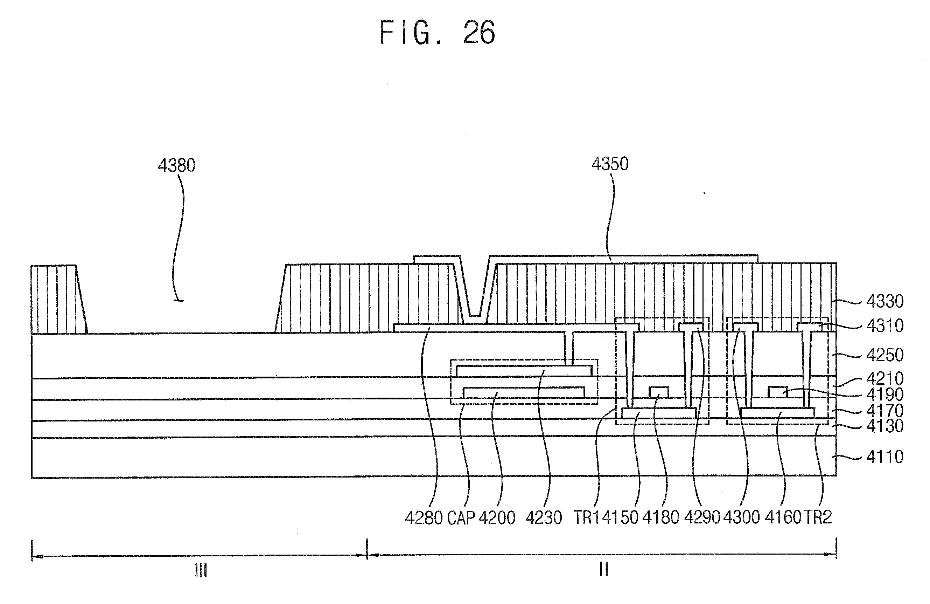

Referring to FIG. 26, a first electrode 4350 is formed on the second insulating layer 4330.

The first electrode 4350 may be disposed on a portion of the first insulating layer 4250, a portion of the power supply electrode 4280, and a portion of the second insulating layer 4330 in the light-emitting region II. In exemplary embodiments, the first electrode 4350 may be disposed to have a substantially uniform thickness along a profile of the power supply electrode 4280 and the second insulating layer 1330.

The first electrode 4350 may include at least one of metal, alloy, metal nitride, conductive metal oxide, a transparent conductive material, etc. For example, the first electrode 4350 may include at least one of aluminum (Al), aluminum alloy, aluminum nitride (AlNx), silver (Ag), silver alloy, tungsten (W), tungsten nitride (WNx), copper (Cu), copper alloy, nickel (Ni), chromium (Cr), chromium nitride (CrNx), molybdenum (Mo), molybdenum alloy, titanium (Ti), titanium nitride (TiNx), platinum (Pt), tantalum (Ta), tantalum nitride (TaNx), neodymium (Nd), scandium (Sc), strontium ruthenium oxide (SRO), zinc oxide (ZnOx), indium tin oxide (ITO), tin oxide (SnOx), indium oxide (InOx), gallium oxide (GaOx), indium zinc oxide (IZO), etc.

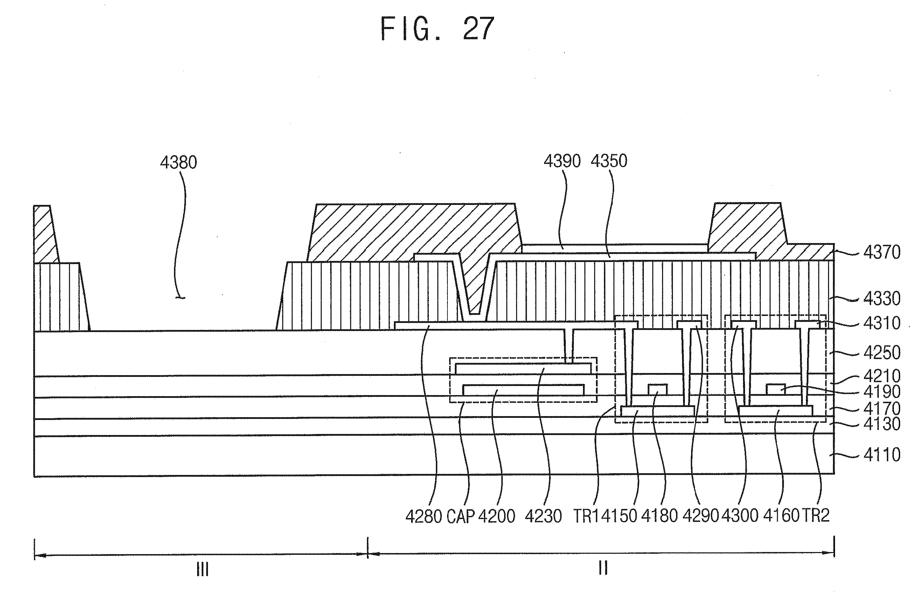

Referring to FIG. 27, a pixel defining layer 4370 is formed on the substrate 4110 on which the first electrode 4350 is formed. Thereafter, an emission layer 4390 is formed on the first electrode 4350 which is exposed via the first opening of the pixel defining layer 4370.

The pixel defining layer 4370 may be disposed on the first electrode 4350, a portion of the second insulating layer 4330, and a portion of the first insulating layer 4250. The pixel defining layer 4370 may include a first opening and a second opening. In the light-emitting region II, the first opening of the pixel defining layer 4370 may be positioned in a portion of the first electrode 4350 disposed on the second insulating layer 4330. The emission layer 4390 may be disposed in the first opening. The second opening of the pixel defining layer 4370 may be positioned in the transparent region III. The second opening may be defined as the transparent window 4380. The pixel defining layer 4370 may include organic materials or inorganic materials used alone or in a combination thereof. In some exemplary embodiments, the pixel defining layer 4370 may include materials substantially the same as that of the second insulating layer 4330.

In the exemplary embodiment shown in FIG. 27, the pixel defining layer 4370 may include an opaque material. For example, the pixel defining layer 4370 may include a white organic material, such as zirconium oxide (ZrOx) and/or titanium oxide (TiOx). In this manner, the pixel defining layer 4370 may block light due to reflection by metal wirings. The pixel defining layer 4370 may block light incident to the light-emitting region II, and thus blurring of images may be prevented or reduced.

However, exemplary embodiments are not limited thereto. For example, the pixel defining layer 4370 may include organic materials of various colors. For example, the pixel defining layer 4370 may include an opaque organic material having a red color, a green color, or a blue color.

The emission layer 4390 may be disposed on the first electrode 4350 which is exposed via the first opening of the pixel defining layer 4370. The emission layer 4390 may be formed using light emitting materials capable of generating different colors of light (e.g., a red color of light, a blue color of light, and a green color of light). However, in some exemplary embodiments, the emission layer 4390 may generally generate a white color of light by stacking a plurality of light emitting materials capable of generating different colors of light such as a red color of light, a green color of light, a blue color of light, etc.

Referring back to FIG. 24, a second electrode 4410 is formed on the substrate 4100 on which the pixel defining layer 4370 is formed.

The second electrode 4410 may be disposed on the pixel defining layer 4370, the emission layer 4390, and the first insulating layer 4250. For example, the second electrode 4410 may be disposed to have a substantially uniform thickness along a profile of the pixel defining layer 4370, the emission layer 4390, and the first insulating layer 4250. The second electrode 4410 may contact a portion of the first insulating layer 4250 via the second opening of the pixel defining layer 4370, and may extend into the transparent region III. That is, the second electrode 4410 may extend into the second opening. In exemplary embodiments, the second electrode 4410 may include a transparent conductive material. For example, the second electrode 4410 may include ITO, SnOx, InOx, GaOx, IZO, etc. Thus, the second electrode 4410 positioned in the transparent region III may not substantially reduce transmittivity of the transparent region III. In some exemplary embodiments, the second electrode 4410 may include materials substantially the same as that of the first electrode 4350.

According to the exemplary embodiment shown in FIG. 27, the pixel defining layer may include an opaque material. Therefore, the pixel defining layer may block light due to reflection by metal wirings. The pixel defining layer may block light incident to the light-emitting region II, and thus blurring of images may be prevented or reduced.

The second insulating layer may also include an opaque material. Therefore, the second insulating layer may block light due to reflection by metal wirings. The second insulating layer may block light incident to the light-emitting region II, and thus blurring of images may be prevented or reduced.

As discussed, embodiments of the invention provide an organic light emitting display device, comprising: a substrate comprising a light-emitting region and a transparent region; a first transistor disposed in the light-emitting region; a second transistor disposed in the light-emitting region and disposed adjacent to the first transistor; a capacitor disposed in the light-emitting region, disposed adjacent to the first transistor, and comprising: a first capacitor electrode; and a second capacitor electrode overlapping with the first capacitor electrode; and a pixel defining layer disposed over the first transistor, the second transistor and the capacitor, comprising a first opening disposed in the light-emitting region and a second opening disposed in the transparent region, the pixel defining layer comprising an opaque material. The second opening may form a transparent window.

In some embodiments, the organic light emitting display device comprises a plurality of pixels, each pixel having a said first transistor, a said second transistor and a said capacity. In some embodiments, these pixels are grouped as red, green and blue sub-pixels. In some embodiments, each set of red, green and blue sub-pixels is associated with a transparent window.

Embodiments of the invention can also provide a method for manufacturing an organic light emitting display device substrate, the method comprising: disposing a buffer layer over a substrate, the substrate comprising a light-emitting region and a transparent region; disposing a first transistor, a second transistor, and a capacitor over the buffer layer in the light-emitting region; and disposing a pixel defining layer over the first transistor, the second transistor, and the capacitor, the pixel defining layer comprising a first opening disposed in the light-emitting region and a second opening disposed in the transparent region, and comprising an opaque material.

Although certain exemplary embodiments and implementations have been described herein, other embodiments and modifications will be apparent from this description. Accordingly, the inventive concept is not limited to such embodiments, but rather to the broader scope of the presented claims and various obvious modifications and equivalent arrangements.

## Claims

1. An organic light emitting display device, comprising:
a substrate comprising a light-emitting region and a transparent region;
a first transistor disposed in the light-emitting region;
a second transistor disposed in the light-emitting region and disposed adjacent to the first transistor;
a capacitor disposed in the light-emitting region, disposed adjacent to the first transistor, and comprising: a first capacitor electrode; and a second capacitor electrode overlapping with the first capacitor electrode; and
a pixel defining layer disposed over the first transistor, the second transistor and the capacitor, comprising a first opening disposed in the light-emitting region and a second opening disposed in the transparent region, the pixel defining layer comprising an opaque material.

2. The organic light emitting display device of claim 1, wherein the pixel defining layer comprises a white organic material.

3. The organic light emitting display device of claim 2, wherein the pixel defining layer comprises at least one of a zirconium oxide (ZrOx) and a titanium oxide (TiOx).

4. The organic light emitting display device of claim 1, wherein the pixel defining layer comprises a black organic material.

5. The organic light emitting display device of claim 4, wherein the pixel defining layer comprises at least one of carbon and cobalt.

6. The organic light emitting display device of any one of claims 1 to 5, further comprising:
an insulation layer disposed over the first transistor, the second transistor, and the capacitor, and disposed under the pixel defining layer, the insulation layer comprising an opaque material.

7. The organic light emitting display device of claim 6, wherein the insulation layer comprises a white organic material.

8. The organic light emitting display device of claim 6, wherein the insulation layer comprises a black organic material.

9. A method for manufacturing an organic light emitting display device substrate, the method comprising:
disposing a buffer layer over a substrate, the substrate comprising a light-emitting region and a transparent region;
disposing a first transistor, a second transistor, and a capacitor over the buffer layer in the light-emitting region; and
disposing a pixel defining layer over the first transistor, the second transistor, and the capacitor, the pixel defining layer comprising a first opening disposed in the light-emitting region and a second opening disposed in the transparent region, and comprising an opaque material.

10. The method of claim 9, the pixel defining layer comprises a white organic material.

11. The method of claim 10, wherein the pixel defining layer comprises at least one of a zirconium oxide (ZrOx) and a titanium oxide (TiOx).

12. The method of claim 9, wherein the pixel defining layer comprises a black organic material.

13. The method of any one of claims 9 to 12, further comprising:
disposing an insulation layer disposed over the first transistor the second transistor and the capacitor, disposed under the pixel defining layer, and comprising an opaque material.

14. The method of claim 13, wherein the insulation layer comprises a white organic material.

15. The method of claim 13, wherein the insulation layer comprises a black organic material.
